# EUROPEAN PATENT APPLICATION

(11) **EP 4 776 778 A1**
(43) Date of publication of application: **15.07.2026**
(21) Application number: 25198055.3
(22) Date of filing: 26.08.2025
(51) Int. Cl.: H10B 12/00

(54) **SEMICONDUCTOR MEMORY DEVICE AND METHOD OF FABRICATING THE SAME**

(30) Priority: 09.01.2025 KR 20250003716
(71) Applicant: Samsung Electronics Co., Ltd., Suwon-si, Gyeonggi-do 16677 (KR)
(72) Inventor: KANG, Jongin, 16677 Suwon-si, Gyeonggi-do (KR); KIM, Youngwoo, 16677 Suwon-si, Gyeonggi-do (KR); LEE, Ji-Eun, 16677 Suwon-si, Gyeonggi-do (KR); LEE, Hoin, 16677 Suwon-si, Gyeonggi-do (KR)
(74) Representative: Kuhnen & Wacker Patent- und Rechtsanwaltsbüro PartG mbB

(57) **Abstract**

A semiconductor memory device includes a substrate including a cell region and a border region, and first to eighth word lines disposed in the substrate to cross the cell region and extending to the border region in a first direction. The first to eighth word lines are sequentially disposed in a second direction, and the first to eighth word lines are sequentially disposed in the order of the first word line, followed by the second word line, followed by the third word line, followed by the fourth word line, followed by the fifth word line, followed by the sixth word line, followed by the seventh word line, and followed by the eighth word line. On the border region, the fourth and eighth word lines extend in the first direction a greater distance than the first to third word lines and the fifth to seventh word lines.

## Description

### CROSS-REFERENCE TO RELATED APPLICATIONS

This U.S. non-provisional patent application claims priority under 35 U.S.C. §119 to Korean Patent Application No. 10-2025-0003716, filed on January 9, 2025, in the Korean Intellectual Property Office, the entire contents of which are hereby incorporated by reference.

### BACKGROUND

The present disclosure relates to a semiconductor memory device and a method of fabricating the same.

Due to their small-sized, multifunctional, and/or low-cost characteristics, semiconductor memory devices are being esteemed as important elements in the electronics industry. With the advancement of the electronics industry, there is an increasing demand for a highly-integrated semiconductor memory device. To increase the integration density of the semiconductor memory device, it is beneficial to reduce linewidths of patterns constituting the semiconductor memory device. However, novel and expensive exposure technologies are needed to reduce the linewidths of the patterns, and thus, it becomes difficult to increase the integration density of the semiconductor memory device. Thus, a variety of new technologies are being recently studied to overcome the difficulty in increasing an integration density of a semiconductor memory device.

### SUMMARY

An embodiment provides a semiconductor memory device with improved reliability.

An embodiment provides a method of reducing a process failure in a process of fabricating a semiconductor memory device.

According to an embodiment, a semiconductor memory device comprises a substrate including a cell region and a border region; and first to eighth word lines disposed in the substrate to cross the cell region and extending to the border region in a first direction, wherein the first to eighth word lines are sequentially disposed in a second direction that is perpendicular to the first direction, and the first to eighth word lines are sequentially disposed in the order of the first word line, followed by the second word line, followed by the third word line, followed by the fourth word line, followed by the fifth word line, followed by the sixth word line, followed by the seventh word line, and followed by the eighth word line, and on the border region, the fourth and eighth word lines extend in the first direction a greater distance than the first to third word lines and the fifth to seventh word lines, when viewed in a plan view.

According to an embodiment, a semiconductor memory device comprises a substrate including a cell region and a border region, first to eighth word lines disposed in the substrate and crossing the cell region and extending to the border region in a first direction, first contact plugs on the border region and in contact with end portions of the second and sixth word lines, and second contact plugs on the border region and in contact with end portions of the fourth and eighth word lines, wherein bottom surfaces of the first contact plugs are at a first level that is different from a second level of bottom surfaces of the second contact plugs.

According to an embodiment, a semiconductor memory device comprises a substrate including a first border region, a cell region, and a second border region, which are arranged along a first direction, a device isolation layer provided in the substrate covering the first and second border regions and defining active regions in the cell region, wherein the active regions are elongated in a second direction that is perpendicular to the first direction, first to eighth word lines disposed in the substrate and extending through the cell region into the first and second border regions in a first direction, the first to eighth word lines extending through the active regions in the first direction, impurity regions provided in the active regions, a data storage pattern connected to one of the impurity regions, a bit line connected to another one of the impurity regions and extending in a third direction that is perpendicular to the first and second directions, first contact plugs on the first border region in contact with end portions of the second and sixth word lines, and second contact plugs on the first border region in contact with end portions of the fourth and eighth word lines, wherein the second contact plugs are offset from the first contact plugs relative to the first direction, when viewed in a plan view.

An embodiment provides a method of fabricating a semiconductor memory device may include forming first to ninth line mask patterns on a substrate including a cell region and a border region, the line mask patterns being extended in a first direction and being separated from each other in a second direction crossing the first direction; forming a first cover mask pattern to cover end portions of the first to ninth line mask patterns on the border region, a side surface of the first cover mask pattern in a plan view being adjacent the cell region, portions recessed in the first direction being formed to expose a space between end portions of the fourth and fifth line mask patterns and a space between end portions of the eighth and ninth line mask patterns; etching the substrate using the first to ninth line mask patterns and the first cover mask pattern as an etch mask to form first to eighth grooves; forming first conductive patterns in the first to eighth grooves; forming a second cover mask pattern on the border region to cover the first conductive patterns, the second cover mask pattern including a cover linear portion extending in the second direction and cover protruding portions protruding from the cover linear portion in the first direction, the cover protruding portions covering the second and sixth grooves and exposing the first, third to fifth, seventh, and eighth grooves; and etching the first conductive patterns using the second cover mask pattern as an etch mask to form line portions and protruding portions in the first conductive patterns.

The method may further include forming second conductive patterns to cover top surfaces of the line portions of the first conductive patterns and to be in contact with side surfaces of the protruding portions.

### BRIEF DESCRIPTION OF THE DRAWINGS

FIG. 1 is a plan view illustrating a semiconductor memory device according to an embodiment.
FIGS. 2A and 2B are enlarged plan views illustrating a portion 'P1' of FIG. 1.
FIG. 3A is a sectional view taken along a line A1-A1' of FIG. 2A.
FIG. 3B is a sectional view taken along a line A2-A2' of FIG. 2A.
FIG. 4A is a sectional view taken along a line B1-B1' of FIG. 2A.
FIG. 4B is a sectional view taken along a line B2-B2' of FIG. 2A.
FIG. 5 is an enlarged sectional view illustrating a portion 'P2' of FIG. 4B.
FIG. 6A is a perspective view illustrating a portion of FIG. 2A.
FIG. 6B is a perspective view illustrating a portion of FIG. 2B.
FIGS. 7A and 7B are plan views illustrating a semiconductor memory device according to an embodiment.
FIG. 8A is a sectional view taken along a line C-C' of FIG. 2A.
FIG. 8B is a sectional view taken along a line D-D' of FIG. 2A.
FIG. 8C is a sectional view taken along a line E-E' of FIG. 2A.
FIGS. 9A to 17A are plan views sequentially illustrating a process of fabricating the semiconductor memory device having the planar structure of FIG. 2A.
FIGS. 9B and 11B to 17B are sectional views taken along lines A1-A1' of FIGS. 9A and 11A to 17A.
FIGS. 9C and 11C to 17C are sectional views taken along lines A2-A2' of FIGS. 9A and 11A to 17A.
FIGS. 9D, 10B, and 11D to 17D are sectional views taken along lines B1-B1' and B2-B2' of FIGS. 9A to 17A.

### DETAILED DESCRIPTION

Example embodiments s will now be described more fully with reference to the accompanying drawings, in which example embodiments are shown.

Throughout the specification, when a component is described as "including" a particular element or group of elements, it is to be understood that the component is formed of only the element or the group of elements, or the element or group of elements may be combined with additional elements to form the component, unless the context clearly and/or explicitly describes the contrary.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

As used herein, components described as being "electrically connected" are configured such that an electrical signal can be transferred from one component to the other (although such electrical signal may be attenuated in strength as it is transferred and may be selectively transferred).

Spatially relative terms, such as "beneath," "below," "lower," "above," "upper," "top," "bottom," "front," "rear," and the like, may be used herein for ease of description to describe positional relationships, such as illustrated in the figures, for example. It will be understood that the spatially relative terms encompass different orientations of the device in addition to the orientation depicted in the figures.

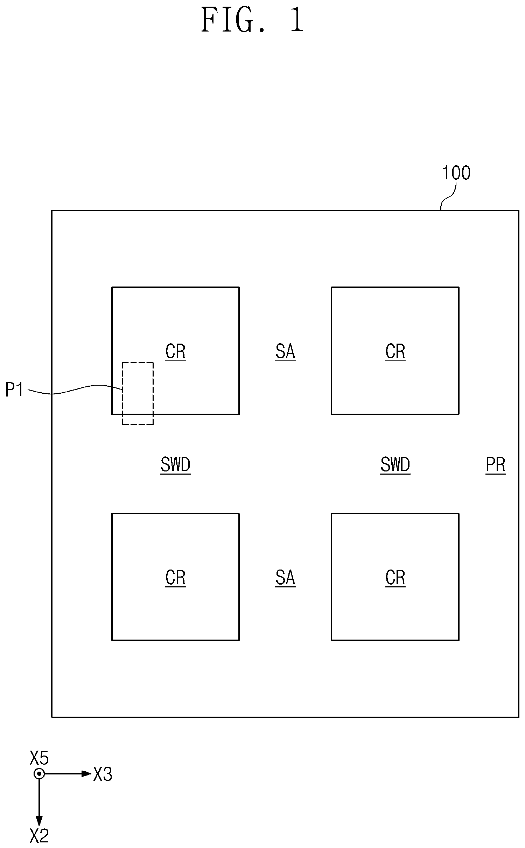

FIG. 1 is a plan view illustrating a semiconductor memory device according to an embodiment.

Referring to FIG. 1, a semiconductor memory device may include a substrate 100. The substrate 100 may be an initial substate (base substrate) on which additional layers are formed, such as a crystalline semiconductor substrate (e.g., a bulk semiconductor substrate). For example, the substrate 100 may be formed of or include silicon (Si), germanium (Ge), silicon germanium (SiGe), gallium phosphide (GaP), or gallium arsenide (GaAs). The substrate 100 may be a silicon-on-insulator (SOI) substrate or a germanium-on-insulator (GOI) substrate.

The substrate 100 may include a plurality of cell regions CR, which are two-dimensionally arranged in two orthogonal directions (e.g., a second direction X2 and a third direction X3). The number and the arrangement of the cell regions CR are not limited to those shown in FIG. 1 and may be variously changed. A peripheral region PR may be disposed between the cell regions CR. The peripheral region PR may be provided to enclose each of the cell regions CR. A plurality of memory cells may be disposed in the cell region CR. Each of the memory cells may be connected to a word line and a bit line crossing each other. A core circuit or a peripheral circuit may be disposed in the peripheral region PR. The peripheral circuit may include a row decoder, a column decoder, a control logic circuit, and so forth.

The core circuit of the peripheral region PR may include sense amplifier (SA) circuits and sub-word line driver (SWD) circuits. The peripheral region PR may further include power and ground driver circuits for driving a sense amplifier, but the present application is not limited to this example.

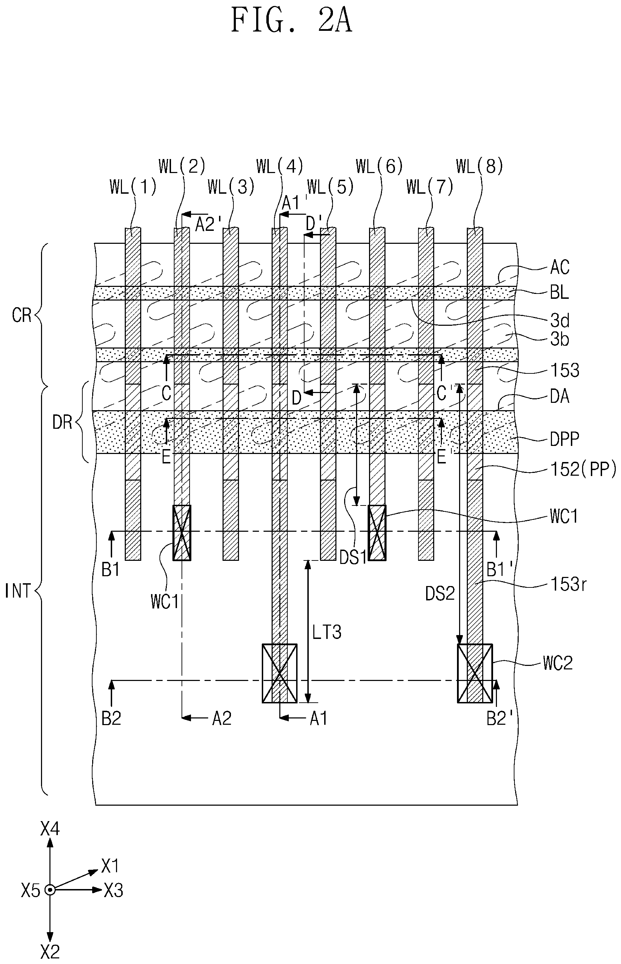

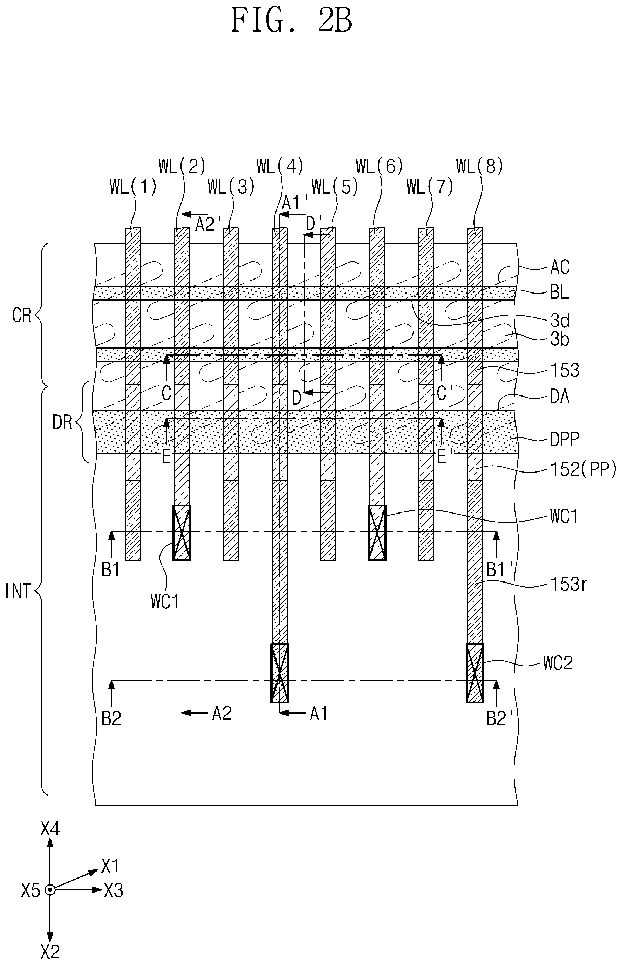

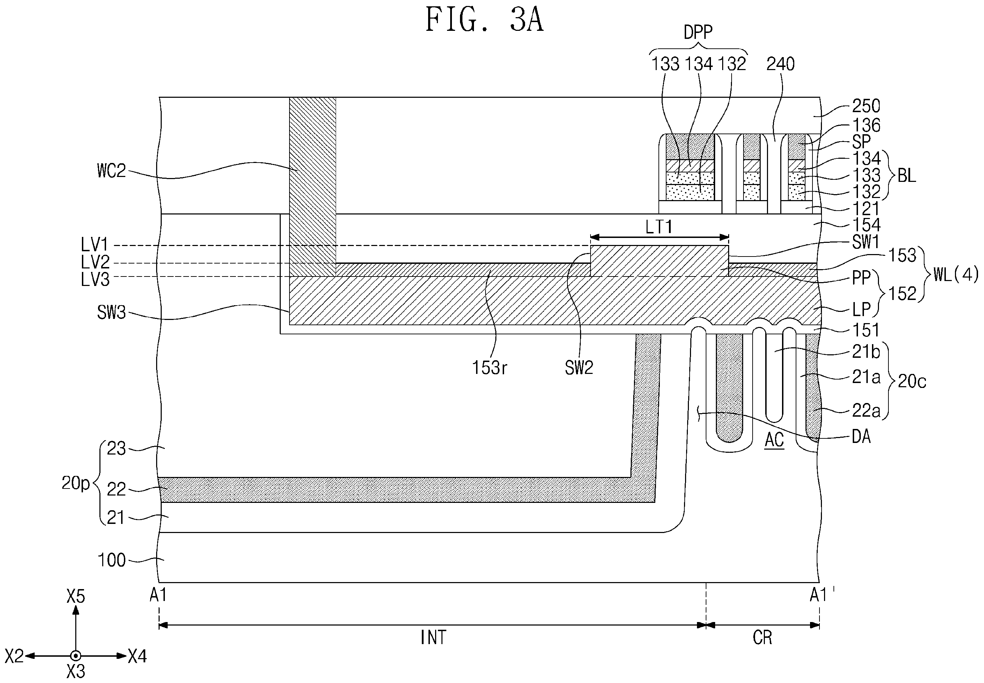

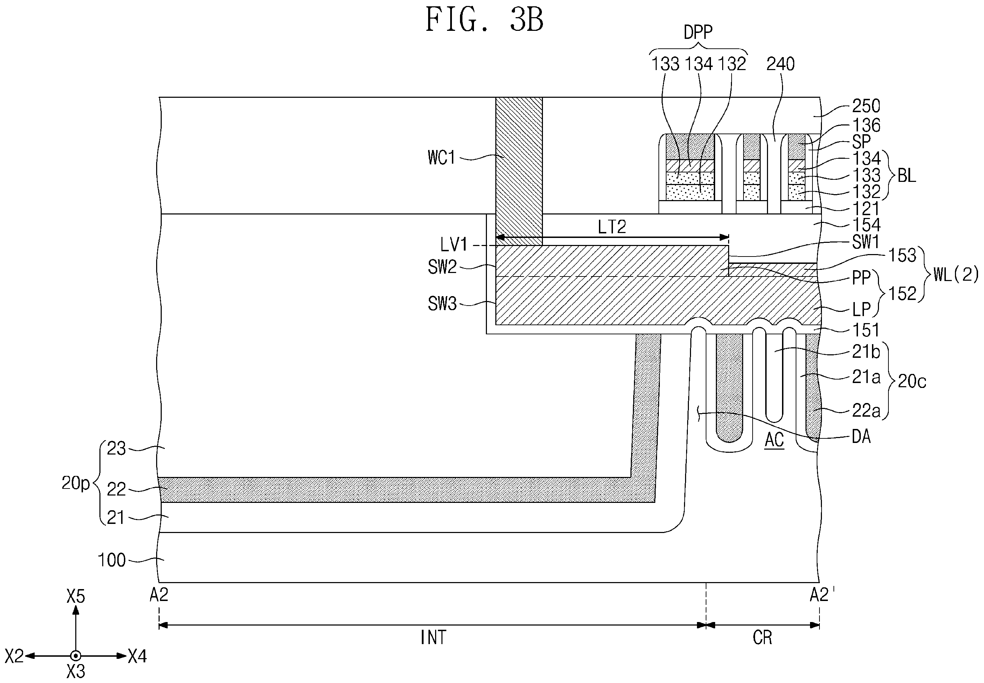

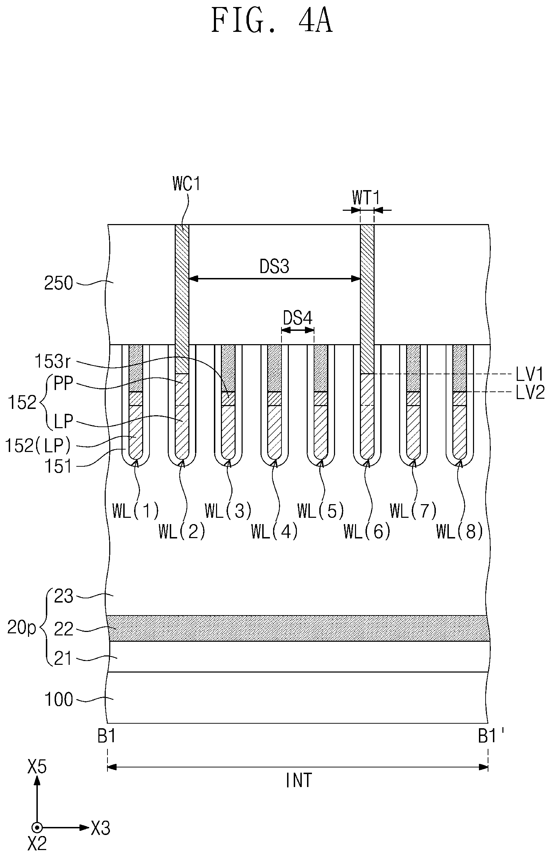

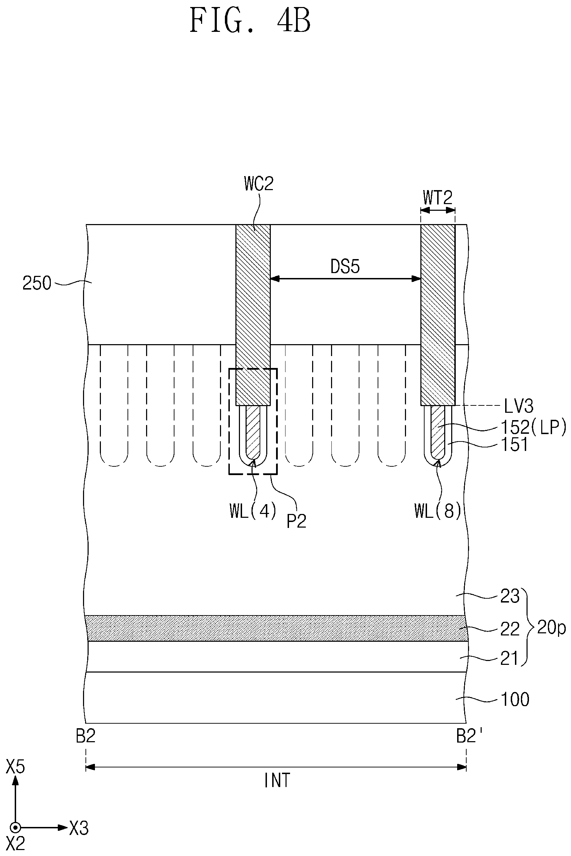

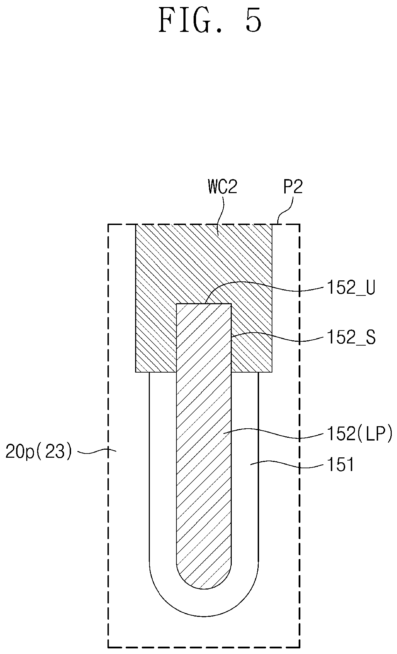

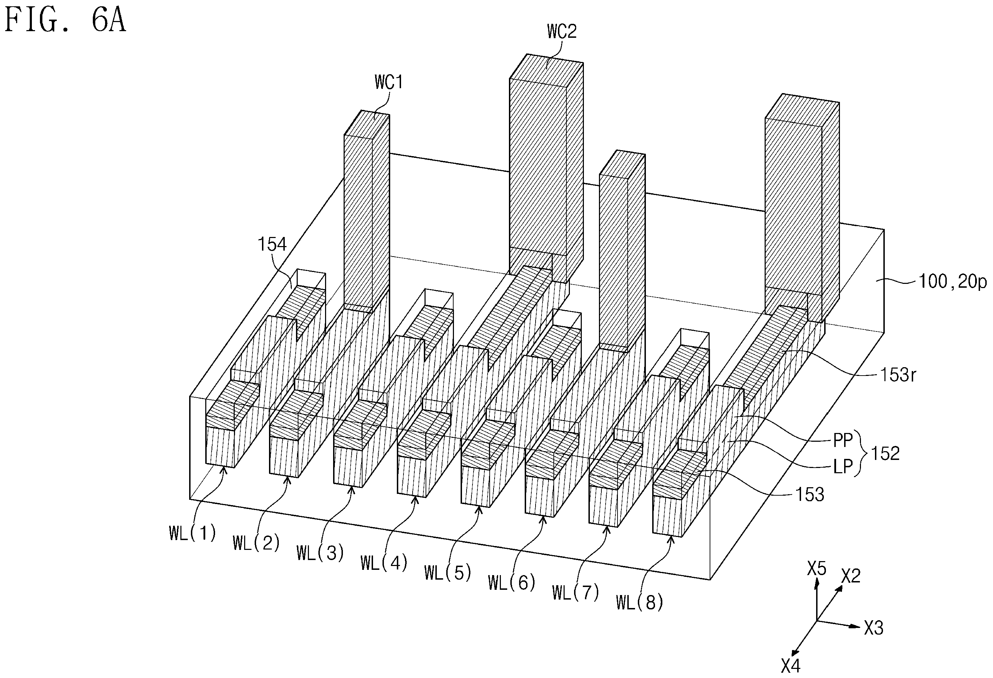

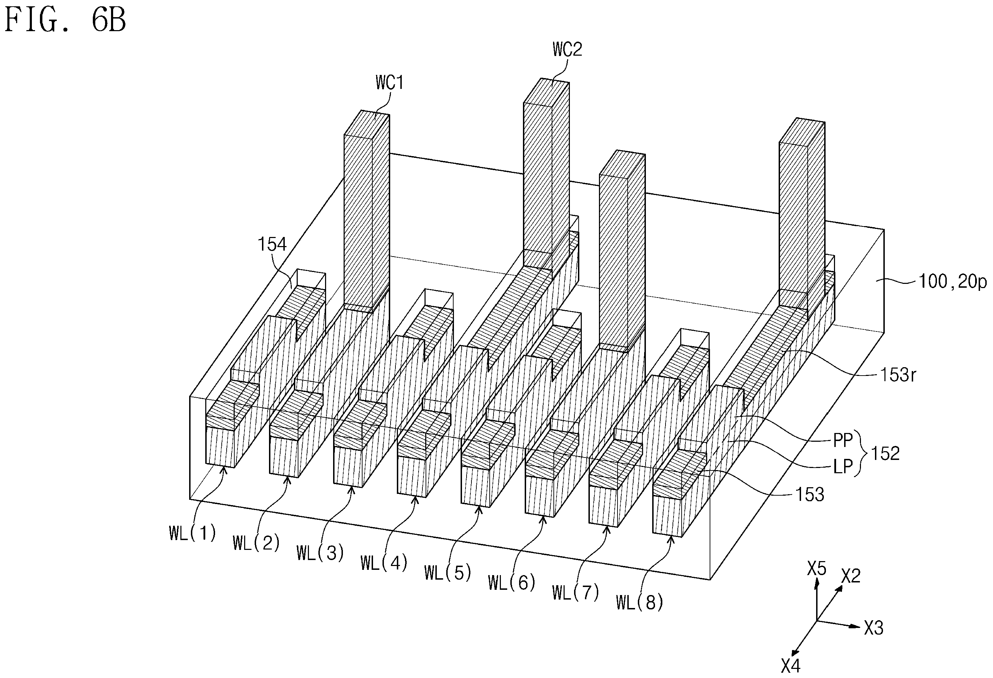

FIGS. 2A and 2B are enlarged plan views illustrating a portion 'P1' of FIG. 1. FIG. 3A is a sectional view taken along a line A1-A1' of FIG. 2A. FIG. 3B is a sectional view taken along a line A2-A2' of FIG. 2A. FIG. 4A is a sectional view taken along a line B1-B1' of FIG. 2A. FIG. 4B is a sectional view taken along a line B2-B2' of FIG. 2A. FIG. 5 is an enlarged sectional view illustrating a portion 'P2' of FIG. 4B. FIG. 6A is a perspective view illustrating a portion of FIG. 2A. FIG. 6B is a perspective view illustrating a portion of FIG. 2B.

Referring to FIGS. 2A and 3A, the semiconductor memory device may include the substrate 100. The substrate 100 may include the cell region CR and a border region INT which are arranged in parallel in the second direction X2. The border region INT may be a region that is located between the cell region CR and the peripheral region PR shown in FIG. 1. The border region INT may include a dummy region DR adjacent to the cell region CR.

First and second device isolation portions 20c and 20p may be disposed in the substrate 100. The first device isolation portion 20c may be disposed in the cell and dummy regions CR and DR to define cell active regions AC and dummy active regions DA. The cell and dummy active regions AC and DA may be elongated in a first direction X1, as illustrated in FIG. 2A, and may be spaced apart from each other. The cell active regions AC may be used to realize a memory function, and the dummy active regions DA may not be used to realize the memory function and may be formed to prevent a loading effect in the fabrication process.

In the drawings, the first to fourth directions X1 to X4 may be parallel to a top surface of the substrate 100, and a fifth direction X5 may be perpendicular to the top surface of the substrate 100. The second direction X2 may be an opposite direction of the fourth direction X4. The first and third directions X1 and X3 may not be parallel to each other and may not be parallel to the second and fourth directions X2 and X4. The third direction X3 may be perpendicular to the second and fourth directions X2 and X4.

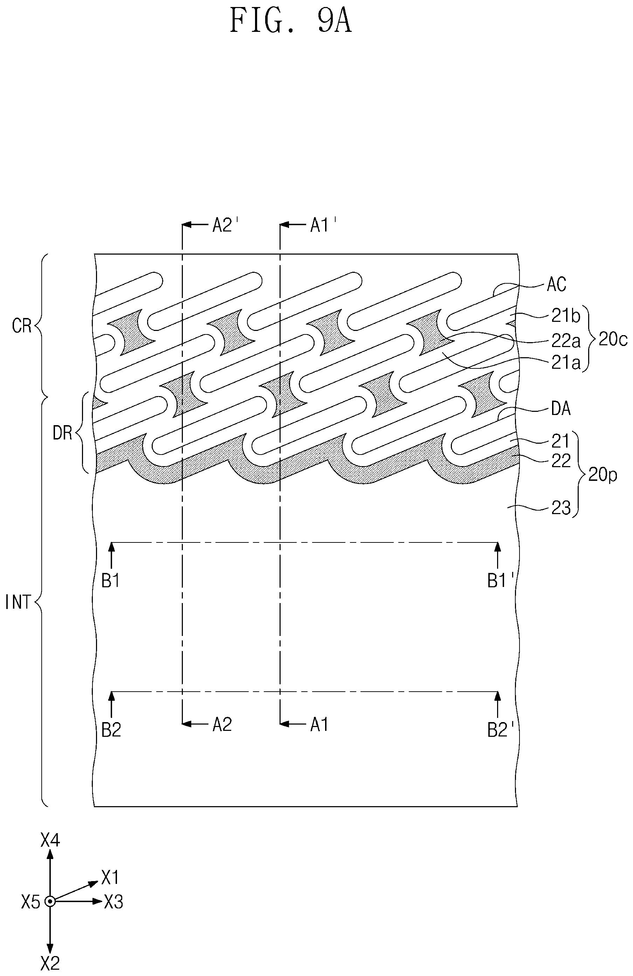

The second device isolation portion 20p may be disposed in the border region INT to define a boundary between the cell region CR and the peripheral region PR. The first device isolation portion 20c may include a first insulating liner 21a, a first gapfill pattern 21b, and a second gapfill pattern 22a. The second device isolation portion 20p may include a second insulating liner 21, a third insulating liner 22, and a second gapfill pattern 23. The first insulating liner 21a, the first gapfill pattern 21b, the second insulating liner 21, and the second gapfill pattern 23 may be formed of the same insulating material (e.g., silicon oxide). The second gapfill pattern 22a and the third insulating liner 22 may be formed of or include the same insulating material (e.g., silicon nitride). Referring to FIG. 9A, the second gapfill pattern 22a may form island-shaped patterns (e.g., discrete separated elements comprising distinct boundaries and surrounded by the first insulating liner 21a and the first gapfill pattern 21b), which are placed between the cell active regions AC, when viewed in a plan view. The first insulating liner 21a may be connected to the first gapfill pattern 21b and the second insulating liner 21. The second insulating liner 21 may be extended in the third direction X3, when viewed in a plan view, and may have an uneven side surface.

Referring to FIGS. 2A, 3A, and 3B, word lines WL may be disposed in the substrate 100 to cross the active regions AC and DA in the second direction X2. The word lines WL may extend to the border region INT in the second direction X2 to cross the cell region CR. The word lines WL may include a plurality of word lines, for example, first to eighth word lines WL(1) to WL(8), which are sequentially arranged in the third direction X3. For example, by being sequentially arranged or disposed, the first to eighth word lines WL(1) to WL(8) may be sequentially disposed in the order of the first word line WL(1), followed by the second word line WL(2), followed by the third word line WL(3), followed by the fourth word line WL(4), followed by the fifth word line WL(5), followed by the sixth word line WL(6), followed by the seventh word line WL(7), and followed by the eighth word line WL(8). The first word line WL(1) may be immediately adjacent to the second word line WL(2), with zero other word lines between the first word line WL(1) and the second word line WL(2). The second word line WL(2) may be immediately adjacent to the third word line WL(3), with zero other word lines between the second word line WL(2) and the third word line WL(3). The third word line WL(3) may be immediately adjacent to the fourth word line WL(4), with zero other word lines between the third word line WL(3) and the fourth word line WL(4). The fourth word line WL(4) may be immediately adjacent to the fifth word line WL(5), with zero other word lines between the fourth word line WL(4) and the fifth word line WL(5). The fifth word line WL(5) may be immediately adjacent to the sixth word line WL(6), with zero other word lines between the fifth word line WL(5) and the sixth word line WL(6). The sixth word line WL(6) may be immediately adjacent to the seventh word line WL(7), with zero other word lines between the sixth word line WL(6) and the seventh word line WL(7). The seventh word line WL(7) may be immediately adjacent to the eighth word line WL(8), with zero other word lines between the seventh word line WL(7) and the eighth word line WL(8). In the border region INT, the fourth and eighth word lines WL(4) and WL(8) may be extended in the second direction X2 to protrude by a third length LT3, when compared to the first to third word lines WL(1) to WL(3) and the fifth to seventh word lines WL(5) to WL(7), when viewed in a plan view. That is, end portions of the fourth and eighth word lines WL(4) and WL(8) may not be overlapped with end portions of the first to third word lines WL(1) to WL(3) and end portions of the fifth to seventh word lines WL(5) to WL(7) in the third direction X3, when viewed in a plan view. The end portions of the fourth and eighth word lines WL(4) and WL(8) may be aligned to each other in the third direction X3, when viewed in a plan view. The end portions of the first to third word lines WL(1) to WL(3) and the end portions of the fifth to seventh word lines WL(5) to WL(7) may be aligned to each other in the third direction X3, when viewed in a plan view.

Accordingly, in embodiments, a first group of word lines WL (e.g., one or more word lines) may each have an end that extends to, and terminates at, a first location along the second direction X2, and a second group of word lines WL (e.g., one or more word lines) may each have an end that extends to, and terminates at, a second location along the second direction X2. As illustrated in FIG. 2A, the first group of word lines WL comprises the fourth word line WL(4) and the eighth word line WL(8), and this first group of word lines WL(4), WL(8) may be spaced apart from one another (e.g., along the third direction X3) and may terminate at the same first location along the second direction X2. As illustrated in FIG. 2A, the second group of word lines WL comprises the first to third word lines WL(1) to WL(3) and the fifth to seventh word lines WL(5) to WL(7), and this second group of word lines WL(1), WL(2), WL(3), WL(5), WL(6), WL(7) may be spaced apart from one another (e.g., along the third direction X3) and may terminate at the same second location along the second direction X2. The second location may be different than the first location. In embodiments, the first location (e.g., at the ends of the first group of word lines) may be in further proximity from the cell region CR than the second location (e.g., at the ends of the second group of word lines). As such, a first distance, measured parallel to the second direction X2, between the cell region CR and the first location is smaller than a second distance, measured parallel to the second direction X2, between the cell region CR and the second location. As illustrated in FIG. 2A, the third length LT3 may represent a separating distance along the second direction X2 between the first location (e.g., at the ends of the first group of word lines) and the second location (e.g., at the ends of the second group of word lines). In embodiments, the word lines that form the first group of word lines, for example, the fourth word line WL(4) and the eighth word line WL(8), may not be adjacent to one another. Rather, one or more word lines (e.g., the fifth to seventh word lines WL(5) to WL(7)) from the second group may be positioned between the fourth word line WL(4) and the eighth word line WL(8) along the third direction X3. Accordingly, the first group of word lines (e.g., WL(4), WL(8)) may extend into the border region INT in the second direction X2 a greater distance than the second group of word lines (WL(1), WL(2), WL(3), WL(5), WL(6), WL(7)) extends into the border region INT in the second direction X2.

Referring to FIGS. 3A and 3B, in the active regions AC and DA, the top surface of the substrate 100 may protrude upward, when compared to top surfaces of the device isolation portions 20c and 20p. For example, the top surface of the substrate 100 (e.g., adjacent to the device isolation portion 20c) may be at a different level than a top surface of the device isolation portions 20c and 20p relative to the fifth direction X5. As illustrated in FIGS. 3A and 3B, the top surface of the substrate 100 may be at a level that is higher than a level of the top surface of the device isolation portions 20c and 20p. A gate insulating layer 151 may be interposed between the word lines WL and the substrate 100. The gate insulating layer 151 may be formed of or include at least one of silicon oxide and/or high-k dielectric materials having a higher dielectric constant than silicon oxide. The high-k dielectric material may include a metal oxide material.

Referring to FIGS. 3A and 3B, each of the word lines WL may include a first conductive pattern 152 and a second conductive pattern 153 thereon. The first conductive pattern 152 may be formed of or include at least one of tungsten or titanium nitride. The second conductive pattern 153 may be formed of or include doped polysilicon. The first conductive pattern 152 may include a line portion LP and a protruding portion PP, which is provided on and connected to the line portion LP to form a single object. The line portion LP of the first conductive pattern 152 may extend to the border region INT to cross the cell region CR. The protruding portion PP may be disposed on the border region INT, for example, at a junction between the border region INT and the cell region CR and adjacent to the cell region CR. The protruding portion PP may protrude upward, when compared to the second conductive pattern 153. A top surface of the protruding portion PP may be placed at a first level LV1. A top surface of the second conductive pattern 153 may be placed at a second level LV2 lower than the first level LV1. The protruding portion PP may have a first side surface SW1, which is adjacent to the cell region CR, and a second side surface SW2, which is opposite to the first side surface SW1. The first and second side surfaces SW1, SW2 may extend from a top surface of the protruding portion PP, through the second conductive pattern 153, and to a top surface of the line portion LP. On the border region INT, the line portion LP may have a third side surface SW3, with the third side surface SW3 defining an end of the line portion LP in the border region INT.

For the first to eighth word lines WL(1) to WL(8), the first side surfaces SW1 of the protruding portions PP may be aligned to each other in the third direction X3. For example, the first side surfaces SW1 of the protruding portions PP of each of the first to eighth word lines WL(1) to WL(8) may lie within a plane, wherein the plane may extend in the third direction X3. For the first, third to fifth, seventh, and eighth word lines WL(1), WL(3) to WL(5), WL(7), and WL(8), the protruding portion PP may have a first length LT1 in the second direction X2, as shown in FIG. 3A. For the second and sixth word lines WL(2) and WL(6), the protruding portion PP may have a second length LT2 of FIG. 3B. The first length LT1 may be smaller than the second length LT2. Accordingly, the protruding portion PP of one or more of the word lines may have a different length than the protruding portion PP of other word lines.

For one or more of the word lines (e.g., the first, third to fifth, seventh, and eighth word lines WL(1), WL(3) to WL(5), WL(7), and WL(8), for example), the third side surface SW3 may be spaced apart from the second side surface SW2 in the second direction X2. For example, as illustrated in FIG. 3A, the second side surface SW2 may not be co-planar with the third side surface SW3, such that the second side surface SW2 and the third side surface SW3 may lie in different planes and are spaced apart from one another. For one or more of the other word lines (e.g., the second and sixth word lines WL(2) and WL(6), for example), the third side surface SW3 may be vertically aligned with, and co-planar with, the second side surface SW2.

In the border region INT, second remaining conductive patterns 153r may be disposed on the line portions LP of the first, third to fifth, seventh, and eighth word lines WL(1), WL(3) to WL(5), WL(7), and WL(8). The second remaining conductive pattern 153r and the second conductive pattern 153 may be spaced apart from each other, with the producing portion PP positioned between the second remaining conductive pattern 153r and the second conductive pattern 153, and may be formed of the same material. The second remaining conductive pattern 153r may be in contact with the second side surface SW2, while the second conductive pattern 153 may be in contact with the first side surface SW1.

Each of the word lines WL may be covered with a first capping pattern 154. The first capping pattern 154 may be formed of silicon nitride. A top surface of the first capping pattern 154 may be coplanar with a top surface of the second device isolation portion 20p.

Referring to FIGS. 3A, 3B, 4A, 4B, 5, 6A, and 6B, the word lines WL and the substrate 100 may be covered with an interlayer insulating layer 250. First contact plugs WC1 may be disposed on the border region INT to penetrate the interlayer insulating layer 250 and the first capping pattern 154 and may be in contact with the top surfaces of the protruding portions PP of the first conductive pattern 152 of the second and sixth word lines WL(2) and WL(6). The first contact plugs WC1 may be aligned relative to each other in the third direction X3, for example, with a first axis extending in the third direction X3 intersecting the first contact plugs WC1.

Second contact plugs WC2 may be disposed on the border region INT to penetrate the interlayer insulating layer 250, the first capping pattern 154, and the second remaining conductive pattern 153r and may be in contact with top surfaces of the line portions LP of the first conductive pattern 152 of the fourth and eighth word lines WL(4) and WL(8). The second contact plugs WC2 may be aligned relative to each other in the third direction X3, for example, with a second axis extending in the third direction X3 intersecting the second contact plugs WC2. With reference to FIGS. 2A and 2B, the second axis (e.g., which is located at the same location as lines B2-B2') may be parallel to, and spaced apart from, the first axis (e.g., which is located at the same location as lines B1-B1'), with the second axis intersecting the second contact plugs WC2 but not intersecting the first contact plugs WC1, and with the first axis intersecting the first contact plugs WC1 but not intersecting the second contact plugs WC2. The first contact plugs WC1 and the second contact plugs WC2 may be formed of or include the same metallic material (e.g., at least one of tungsten, titanium, and cobalt).

The first contact plugs WC1 may be spaced apart from the cell region CR by a first distance. The second contact plugs WC2 may be spaced apart from the cell region CR by a second distance. The second distance may be larger than the first distance. As such, the second contact plugs WC2 may be offset from the first contact plugs WC1 relative to the second direction X2, for example, with the first contact plugs WC1 and the second contact plugs WC2 located at differing locations along the second direction X2. Each of the first contact plugs WC1 may have a first width WT1 in the third direction X3. The second contact plugs WC2 may have a second width WT2 in the third direction X3. The second width WT2 may be larger than the first width WT1, as shown in FIGS. 2A, 4B, and 6A. Alternatively, the second width WT2 may be substantially equal to the first width WT1, as shown in FIGS. 2B and 6B.

Bottom surfaces of the first contact plugs WC1 may be placed at the first level LV1. Bottom surfaces of the second contact plugs WC2 may be placed at a third level LV3 lower than the first level LV1. As shown in FIG. 5, the second contact plugs WC2 may cover a top surface 152_U and a side surface 152_S of the line portion LP of the first conductive pattern 152. Accordingly, a width of the second contact plug WC2 in the third direction X3 may be greater than a width of the line portion LP in the third direction X3, and an upper portion of the line portion LP may extend into a bottom portion of the second contact plug WC2 such that the top surface 152_U and the side surfaces 152_S may be in contact with the second contact plug WC2. In this case, a contact area between the second contact plug WC2 and the line portion LP of the first conductive pattern 152 may be increased, and thus, it may be possible to reduce the resistance characteristics of the second contact plug WC2 and the line portion LP and increase the signal transmission speed of the device.

The first contact plugs WC1 may be spaced apart from each other in the third direction X3 by a third distance DS3. Adjacent word lines WL (e.g., wherein no word lines WL are positioned between adjacent word lines WL) may be spaced apart from each other in the third direction X3 by a fourth distance DS4. The second contact plugs WC2 may be spaced apart from each other in the third direction X3 by a fifth distance DS5. The third distance DS3 and the fifth distance DS5 may be larger than the fourth distance DS4. The fifth distance DS5 may be equal to or smaller than the third distance DS3.

In an embodiment, the end portions of the word lines WL may be formed to have different lengths from each other, and thus, it may be possible to limit the first contact plugs WC1 and the second contact plugs WC2 from being located on the same line, for example, at the same location, along the third direction X3. The second contact plugs WC2 may be offset from the first contact plugs WC1 in the first direction X1. For example, a first distance, which is measured parallel to the second direction X2 and separates the cell region and the first contact plugs WC1, is less than a second distance, which is measured parallel to the second direction X2 and separates the cell region CR and the second contact plugs WC2. That is, according to an embodiment, the first contact plugs WC1 and the second contact plugs WC2 may be arranged in a zigzag shape, and, in some embodiments, may be spaced apart along the first direction X1. The first direction X1 may form an angle relative to the third direction X3 that is less than 90 degrees, or less than 60 degrees, or less than 45 degrees, and the first direction X1 may form an angle relative to the fourth direction X4 that is less than 90 degrees. Thus, it may be possible to reduce the likelihood of a short circuit issue or a bridge issue from occurring between the first contact plugs WC1 and the second contact plugs WC2, by increasing the separating distance between the first contact plugs WC1 and the second contact plugs WC2.

In addition, the first contact plugs WC1 and the second contact plugs WC2 may be formed to have different depths from each other. In an embodiment, since the first level LV1, at which the bottom surfaces of the first contact plugs WC1 are formed, is higher than the second level LV2, at which the top surface of the second remaining conductive pattern 153r of an adjacent word line WL is formed, it may be possible to limit the likelihood of a short circuit issue or a bridge issue from occurring between the first contact plugs WC1 and the word line WL adjacent thereto.

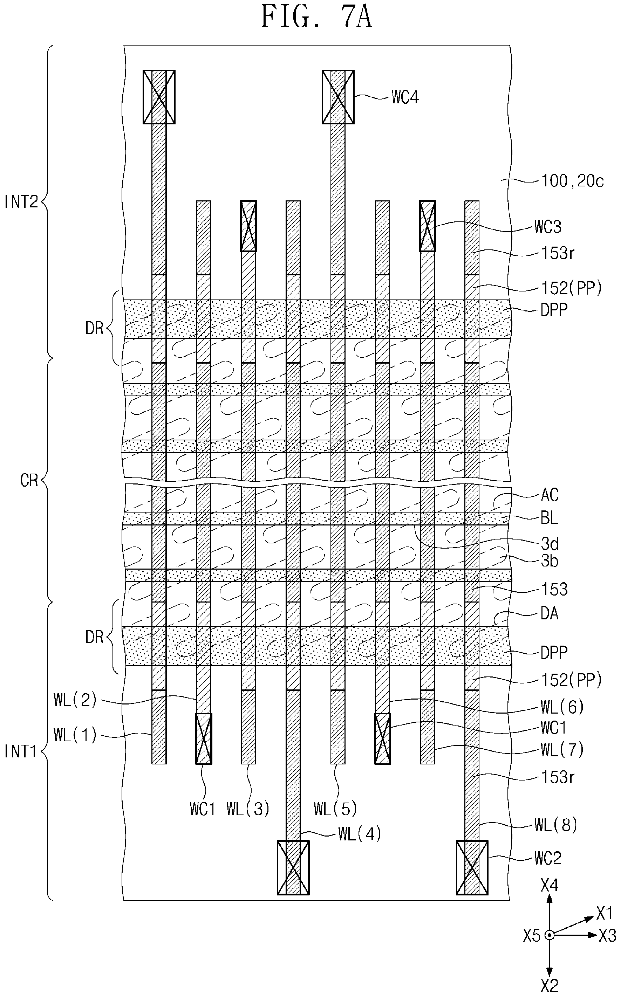

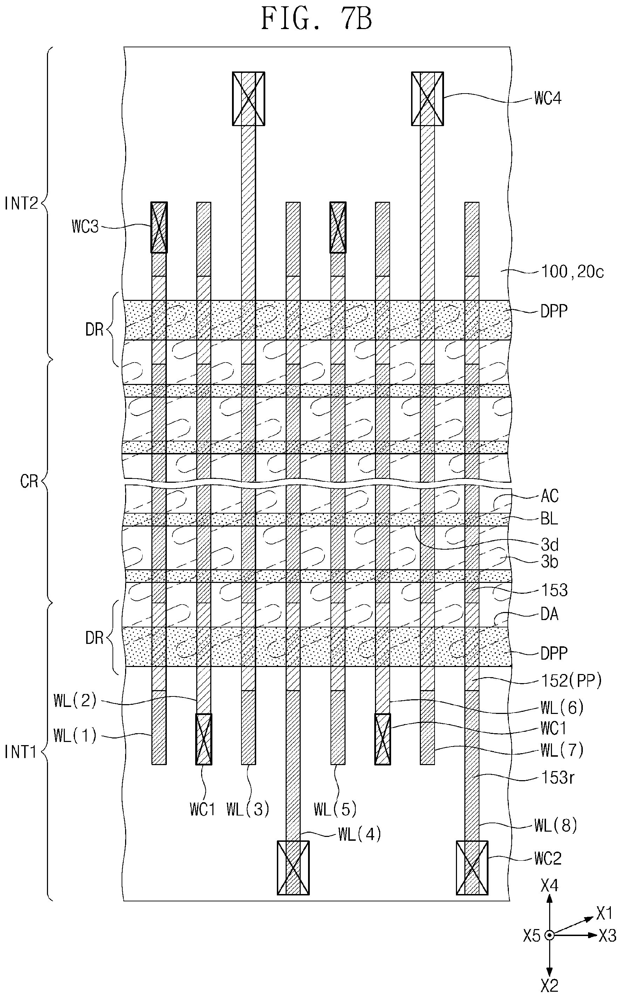

FIGS. 7A and 7B are plan views illustrating a semiconductor memory device according to an embodiment.

Referring to FIGS. 7A and 7B the substrate 100 may include a first border region INT1, a cell region CR, and a second border region INT2, which are sequentially disposed in the fourth direction X4. The word lines WL may extend across the cell region CR in the fourth direction X4 and may reach the first and second border regions INT1 and INT2. In the first border region INT1, the word lines WL and the first and second contact plugs WC1 and WC2 may be provided to have substantially the same shapes and arrangements as those in the embodiment described with reference to FIG. 3A. In the second border region INT2, the first conductive patterns 152 of the word lines WL may have the protruding portions PP.

Referring to FIG. 7A, the protruding portions PP of the third and seventh word lines WL(3) and WL(7) in the second border region INT2 may have the same shape as the protruding portions PP of the second and sixth word lines WL(2) and WL(6) in the first border region INT1. In the second border region INT2, the first and fifth word lines WL(1) and WL(5) may be extended to protrude in the fourth direction X4, when compared to the second to fifth and sixth to eighth word lines WL(2) to WL(5) and WL(6) to WL(8). Third contact plugs WC3 may be in contact with end portions of the third and seventh word lines WL(3) and WL(7). Fourth contact plugs WC4 may be in contact with end portions of the first and fifth word lines WL(1) and WL(5). The third and fourth contact plugs WC3 and WC4 may be arranged in a zigzag shape. For example, similar to the arrangement of the first contact plugs WC1 and second contact plugs WC2 along the first direction X1, the third and fourth contact plugs WC3 and WC4 may also be arranged along the first direction X1. As illustrated in FIG. 7A, a third distance separating the third contact plug WC3 from the cell region CR may be less than a fourth distance separating the fourth contact plug WC4 from the cell region CR. A width of the fourth contact plugs WC4 in the third direction X3 may be larger than a width of the third contact plugs WC3.

Referring to FIG. 7B, the protruding portions PP of the first and fifth word lines WL(1) and WL(5) in the second border region INT2 may have the same shape as the protruding portions PP of the second and sixth word lines WL(2) and WL(6) in the first border region INT1. In the second border region INT2, the third and seventh word lines WL(3) and WL(7) may extend in the fourth direction X4, when compared to the first, second, fourth to sixth, and eighth word lines WL(1), WL(2), WL(4) to WL(6), and WL(8). The third contact plugs WC3 may be in contact with end portions of the first and fifth word lines WL(1) and WL(5). The fourth contact plugs WC4 may be in contact with end portions of the third and seventh word lines WL(3) and WL(7). The third and fourth contact plugs WC3 and WC4 may be arranged in a zigzag shape. For example, similar to the arrangement of the first contact plugs WC1 and second contact plugs WC2 along the first direction X1, the third and fourth contact plugs WC3 and WC4 may also be arranged along the first direction X1. As illustrated in FIG. 7B, a third distance separating the third contact plug WC3 from the cell region CR may be less than a fourth distance separating the fourth contact plug WC4 from the cell region CR. A width of the fourth contact plugs WC4 in the third direction X3 may be larger than a width of the third contact plugs WC3.

In the present specification, the structure with eight word lines WL has been described as an example, but the present application is not limited to this example. The number of the word lines WL may be nine or more, and the shapes and arrangements of the word lines WL and the contact plugs WC1 to WC4 described with reference to FIGS. 2A to 7B may be repeated along the third direction X3.

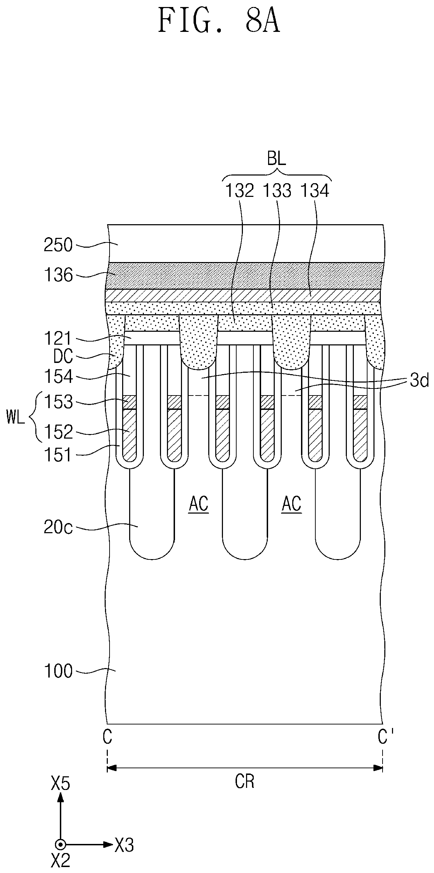

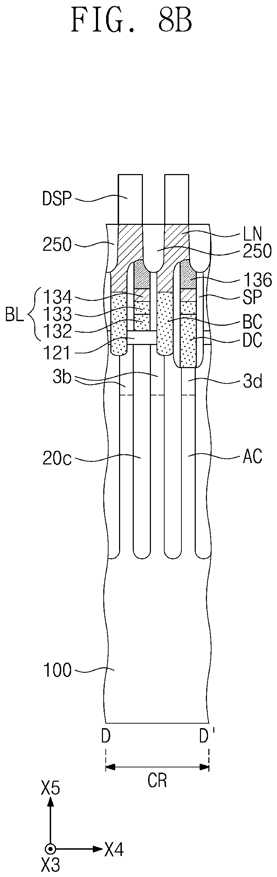

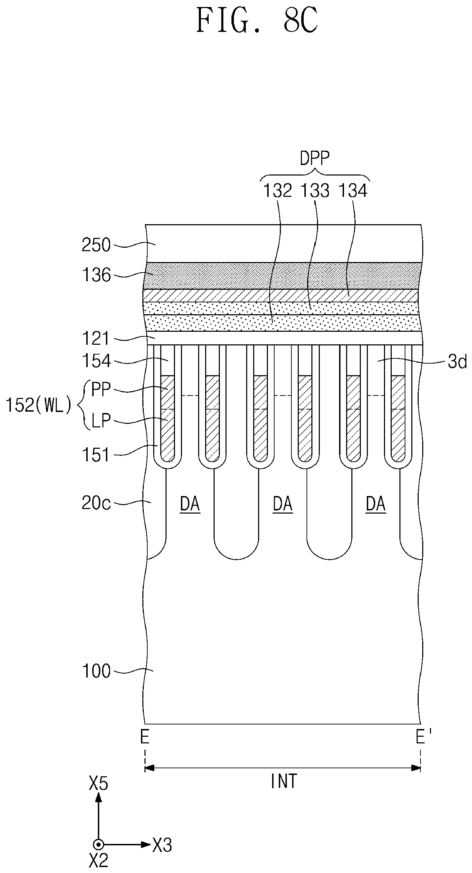

FIG. 8A is a sectional view taken along a line C-C' of FIG. 2A. FIG. 8B is a sectional view taken along a line D-D' of FIG. 2A. FIG. 8C is a sectional view taken along a line E-E' of FIG. 2A.

Referring to FIGS. 2A, 3A, 8A to 8C, a first doping region 3d may be disposed in a center region of each of the active regions AC and DA, and a second doping region 3b may be disposed in an edge region of each of the active regions AC and DA. The first and second doping regions 3d and 3b may be doped with dopants having a conductivity type, which is different from the conductivity type of the substrate 100. For example, the substrate 100 may be doped with p-type dopants, and the first and second doping regions 3d and 3b may be doped with n-type dopants.

A lower insulating layer 121 may be disposed on the cell active region AC. The lower insulating layer 121 may be formed of or include at least one of silicon oxide, silicon nitride, or silicon oxynitride and may have a single- or multi-layered structure.

Bit lines BL may be disposed in the cell region CR and on the lower insulating layer 121. The bit lines BL may extend in the third direction X3 and may be spaced apart from each other in the second direction X2. A dummy pattern DPP may be disposed in the dummy region DR and on the lower insulating layer 121. The dummy pattern DPP may extend in the third direction X3 and may be spaced apart from the bit lines BL. A width of the dummy pattern DPP may be larger than a width of the bit lines BL, wherein the widths are measured along the second direction X2. Each of the bit lines BL and the dummy pattern DPP may include a third conductive pattern 132, a fourth conductive pattern 133, and a fifth conductive pattern 134, which are sequentially stacked. The third and fourth conductive patterns 132 and 133 may be formed of doped polysilicon. The fifth conductive pattern 134 may be formed of a metallic material (e.g., tungsten). Second capping patterns 136 may be provided on the bit lines BL and the dummy pattern DPP. The second capping pattern 136 may be formed of silicon nitride. Side surfaces of the bit lines BL and the dummy pattern DPP may be covered with spacer patterns SP, respectively. The spacer pattern SP may have a multi-layered structure including three or more layers (e.g., including at least one silicon nitride layer and at least one silicon oxide layer). Alternatively, the spacer pattern SP may include an air gap region.

Referring to FIGS. 8A and 8B, a bit line contact plug DC may be provided to penetrate the lower insulating layer 121 and the third conductive pattern 132 and to connect the first doping region 3d to the fourth conductive pattern 133 of the bit line BL. The bit line contact plug DC may be formed of or include at least one of doped polysilicon, tungsten, or titanium. The dummy pattern DPP may be electrically isolated from, and separated from, the first doping region 3d by the lower insulating layer 121, as shown in FIG. 8C.

Referring to FIG. 8B, a storage contact plug BC may be placed between the bit lines BL and may be in contact with the second doping region 3b. The storage contact plug BC may be formed of or include at least one of doped polysilicon, tungsten, or titanium. In an embodiment, a plurality of storage contact plugs BC may be provided and may be island-shaped patterns (e.g., wherein each storage contact plug BC is between bit lines BL in the fourth direction X4), which are two-dimensionally arranged in the third and fourth directions X3 and X4. A first separation insulating pattern 240 of FIG. 3A may be interposed between the bit lines BL and between the storage contact plugs BC. The first separation insulating pattern 240 may be formed of or include at least one of silicon oxide or silicon nitride.

Referring to FIG. 8B, a landing pad LN may be placed on the storage contact plug BC. The landing pad LN may be formed of or include a metallic material (e.g., tungsten). A portion of the landing pad LN may cover a top surface of the second capping pattern 136 on the bit line BL. In an embodiment, a plurality of landing pads LN may be provided and may be island-shaped patterns, which are two-dimensionally arranged in the third and fourth directions X3 and X4. When viewed in a plan view, the landing pads LN may be arranged in a honeycomb shape. The interlayer insulating layer 250 may be disposed between the landing pads LN to separate the landing pads LN from each other.

A data storage pattern DSP may be disposed on the landing pad LN. The data storage pattern DSP may be electrically connected to the landing pad LN. The data storage pattern DSP may be a capacitor including a bottom electrode, a dielectric layer, and a top electrode. In this case, the semiconductor memory device may be a dynamic random-access memory (DRAM) device. Alternatively, the data storage patterns DSP may include a magnetic tunnel junction pattern. In this case, the semiconductor memory device may be a magnetic random access memory (MRAM) device. The data storage patterns DSP may be formed of or include a phase-change material or a variable resistance material. In this case, the semiconductor memory device may be a phase-change random access memory (PRAM) device or a resistive RAM (ReRAM) device. In an embodiment, each of the data storage patterns DSP may include various structures and/or materials capable of storing data.

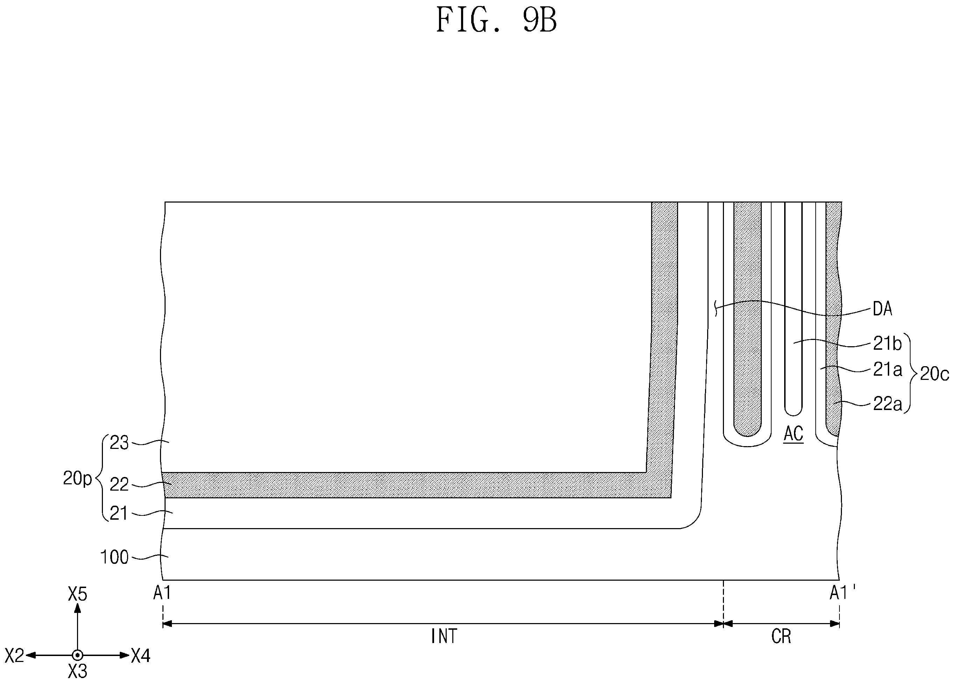

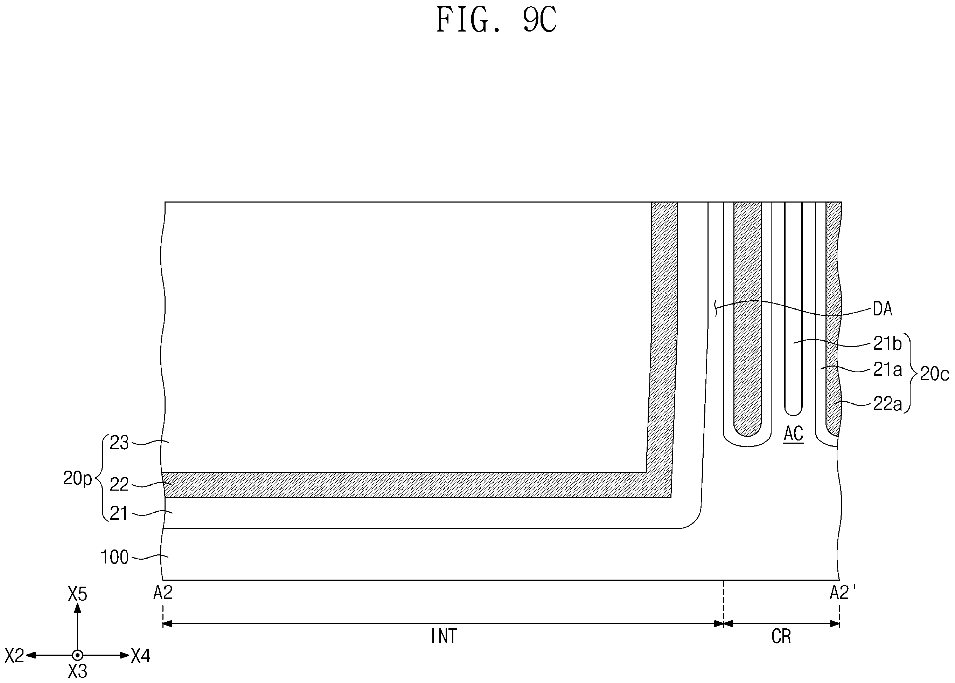

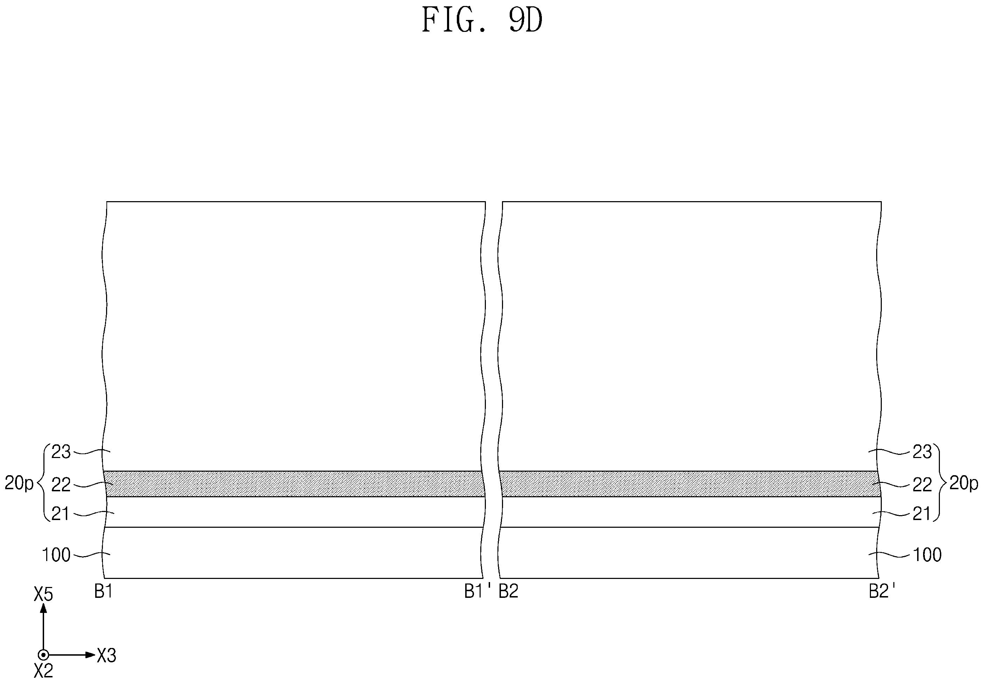

FIGS. 9A to 17A are plan views sequentially illustrating a process of fabricating the semiconductor memory device having the planar structure of FIG. 2A. FIGS. 9B, 11B, 12B, 13B, 14B, 15B, 16B, and17B are sectional views taken along lines A1-A1' of FIGS. 9A and 11A to 17A. FIGS. 9C, 11C, 12C, 13C, 14C, 15C, 16C, and 17C are sectional views taken along lines A2-A2' of FIGS. 9A, 11A, 12A, 13A, 14A, 15A, 16A, and 17A. FIGS. 9D, 10B, 11D, 12D, 13D, 14D, 15D, 16D, and 17D are sectional views taken along lines B1-B1' and B2-B2' of FIGS. 9A, 10A, 11A, 12A, 13A, 14A, 15A, 16A, and 17A.

Referring to FIGS. 9A to 9D, the substrate 100 may be provided. The substrate 100 may include the cell region CR and the border region INT which are arranged in parallel in the second direction X2. The border region INT may be a region that is located between the cell region CR and the peripheral region PR shown in FIG. 1. The border region INT may include the dummy region DR adjacent to the cell region CR.

The substrate 100 may be etched to form trenches defining the active regions AC and DA. The first and second device isolation portions 20c and 20p may be formed by filling the trenches with an insulating material. The first and second device isolation portions 20c and 20p may be formed in the substrate 100. The first device isolation portion 20c may be formed in the cell and dummy regions CR and DR to define the cell and dummy active regions AC and DA. The cell and dummy active regions AC and DA may be elongated in the first direction X1 and may be spaced apart from each other.

The second device isolation portion 20p may be disposed in the border region INT to define a boundary between the cell region CR and the peripheral region PR. The first device isolation portion 20c may include the first insulating liner 21a, the first gapfill pattern 21b, and the second gapfill pattern 22a. The second device isolation portion 20p may include the second insulating liner 21, the third insulating liner 22, and the second gapfill pattern 23. The first insulating liner 21a, the first gapfill pattern 21b, the second insulating liner 21, and the second gapfill pattern 23 may be formed of or include the same insulating material (e.g., silicon oxide). The second gapfill pattern 22a and the third insulating liner 22 may be formed of or include the same material (e.g., silicon nitride). The second gapfill pattern 22a may be formed as a plurality of island-shaped patterns, which are placed between the cell active regions AC, when viewed in a plan view. The first insulating liner 21a may be connected to the first gapfill pattern 21b and the second insulating liner 21. The second insulating liner 21 may extend in the third direction X3, when viewed in a plan view, and may have an uneven side surface. For example, as illustrated in FIG. 9A, the second insulating liner 21 may be formed with a non-planar side surface, such as, for example, a side surface that may have rounded portions, curved portions, straight portions, etc.

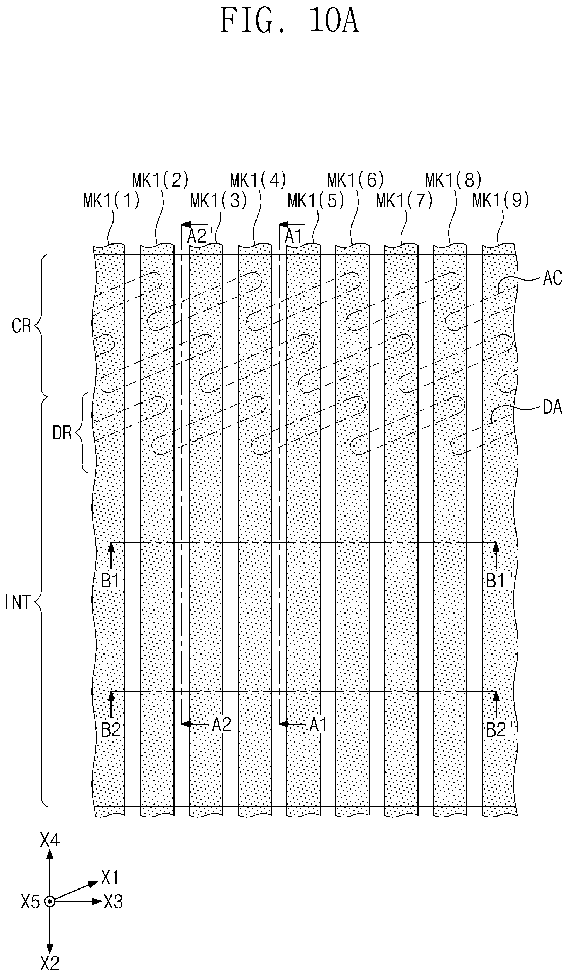

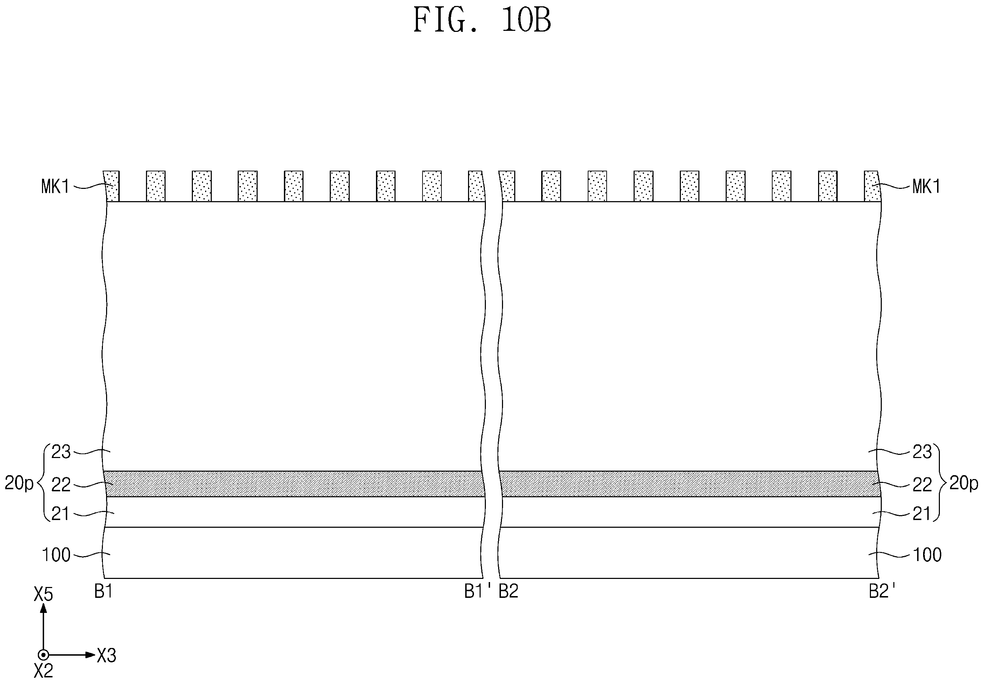

A cross section taken along a line A1-A1' of FIG. 10A is represented by the cross section of FIG. 9B. A cross section taken along a line A2-A2' of FIG. 10B is represented by the cross section of FIG. 9C. Referring to FIGS. 9B, 9C, 10A, and 10B, line mask patterns MK1 may be formed on the substrate 100. The line mask patterns MK1 may include first to ninth line mask patterns MK1(1) to MK(9), which are sequentially disposed, and spaced apart from one another, in the third direction X3. The line mask patterns MK1 may extend to the border region INT in the second direction X2 to cross the cell region CR. The line mask patterns MK1 may be formed using a double patterning technology (DPT) or a quadruple patterning technology (QPT). End portions of some of the line mask patterns MK1 may be connected to each other, on the border region INT. The line mask patterns MK1 may be formed of a material having an etch selectivity with respect to the substrate 100 and the first and second device isolation portions 20c and 20p. The line mask patterns MK1 may be formed to cross the active regions AC and DA. Three adjacent line mask patterns MK1 may overlap one of the active regions AC and DA. For example, three adjacent line mask patterns MK1(1), MK1(2), MK1(3) may, together, overlap an entirety of one of the cell active regions AC and an entirety of one of the dummy active regions DA.

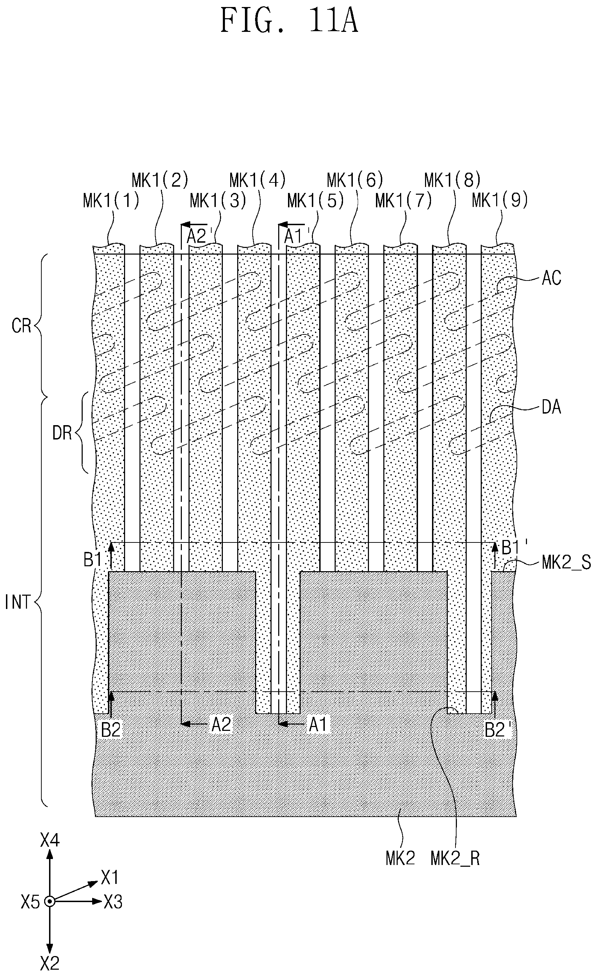

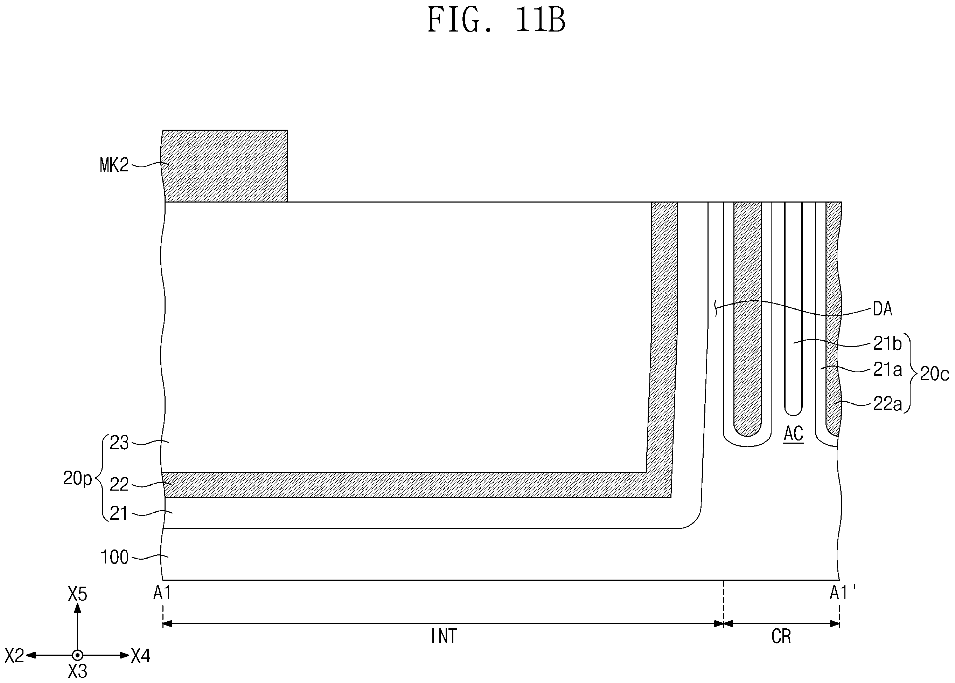

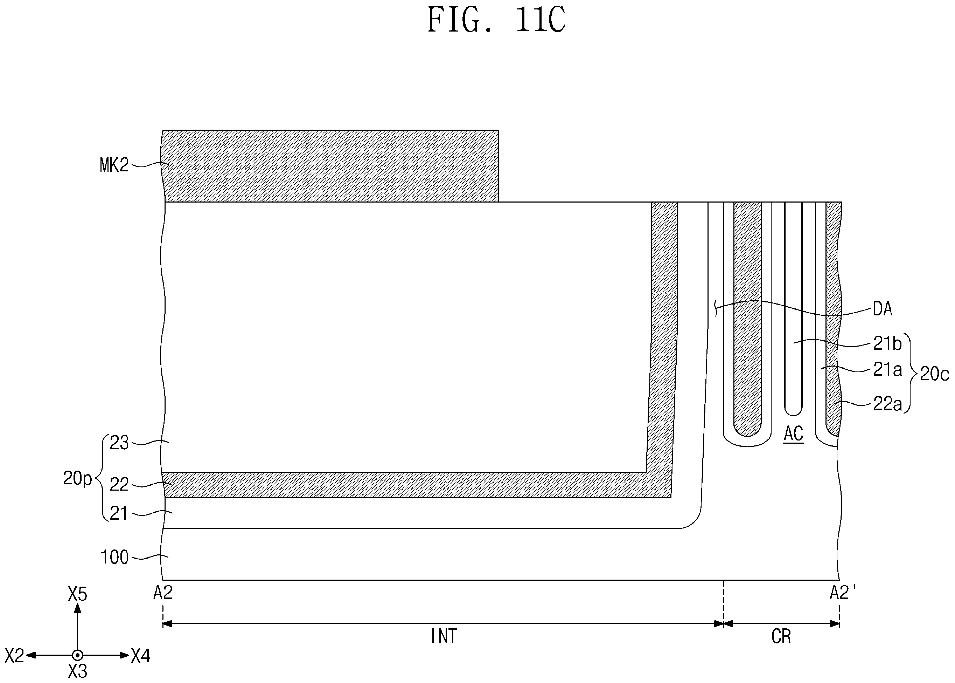

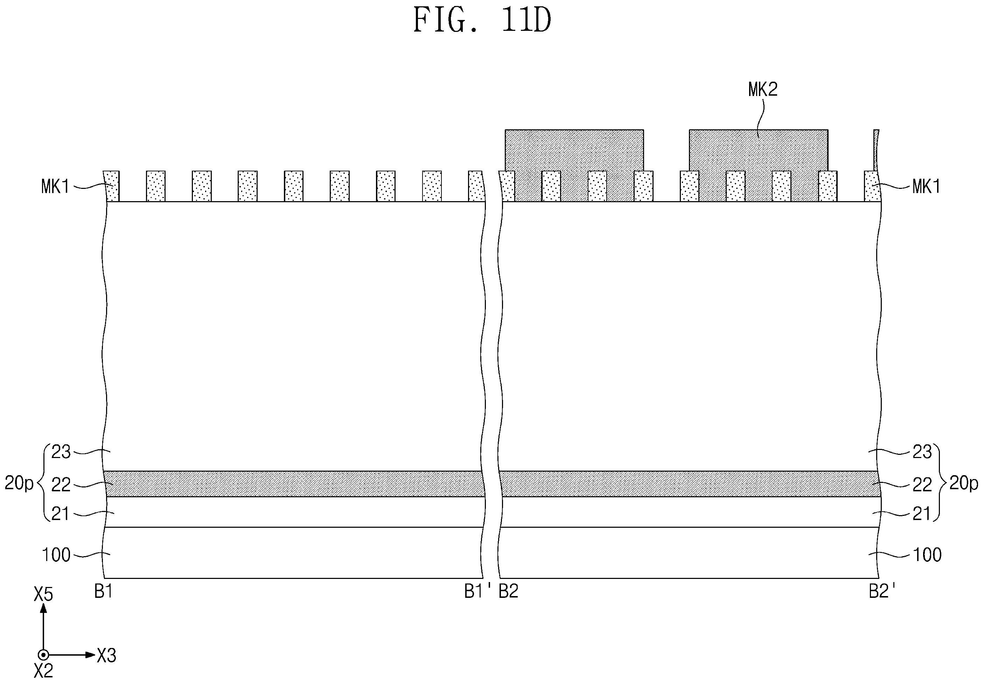

Referring to FIGS. 11A and 11B, a first cover mask pattern MK2 may be disposed on the border region INT to cover end portions of the line mask patterns MK1. When viewed in a plan view, a side surface MK2_S of the first cover mask pattern MK2 faces the cell region CR, and may include recessed portions MK2_R, which are recessed in the second direction X2. The recessed portions MK2_R may expose a space between end portions of the fourth and fifth line mask patterns MK1(4) and MK1(5) and a space between end portions of the eighth and ninth line mask patterns MK1(8) and MK1(9). The first cover mask pattern MK2 may be a photoresist pattern. Since a sixth distance between the recessed portions MK2_R of the first cover mask pattern MK2 (e.g., wherein the sixth distance is between adjacent recessed portions MK2_R in the third direction X3) is larger than a seventh distance between the line mask patterns MK1 (e.g., wherein the seventh distance is between adjacent line mask patterns MK1 in the third direction X3), the first cover mask pattern MK2 may be easily formed without using the EUV exposure process.

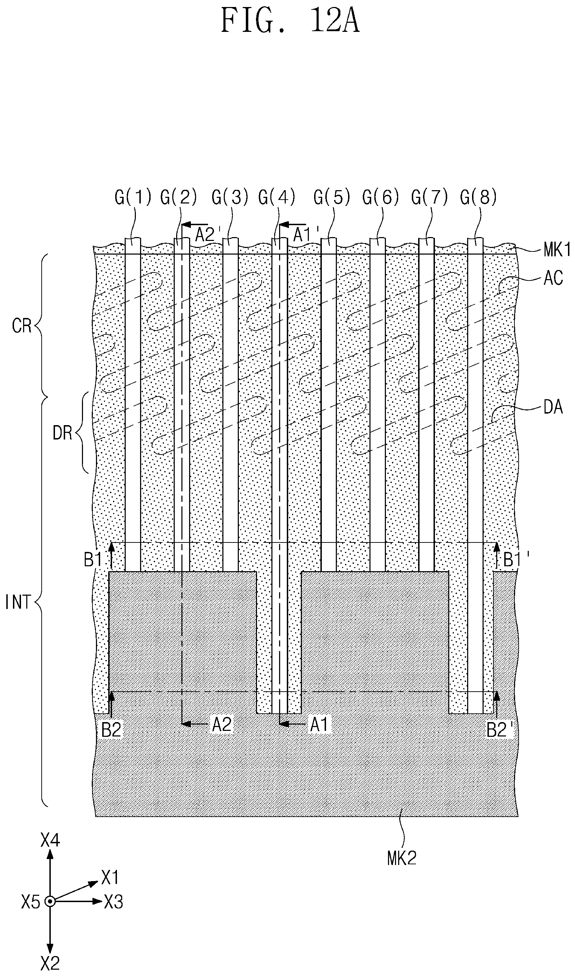

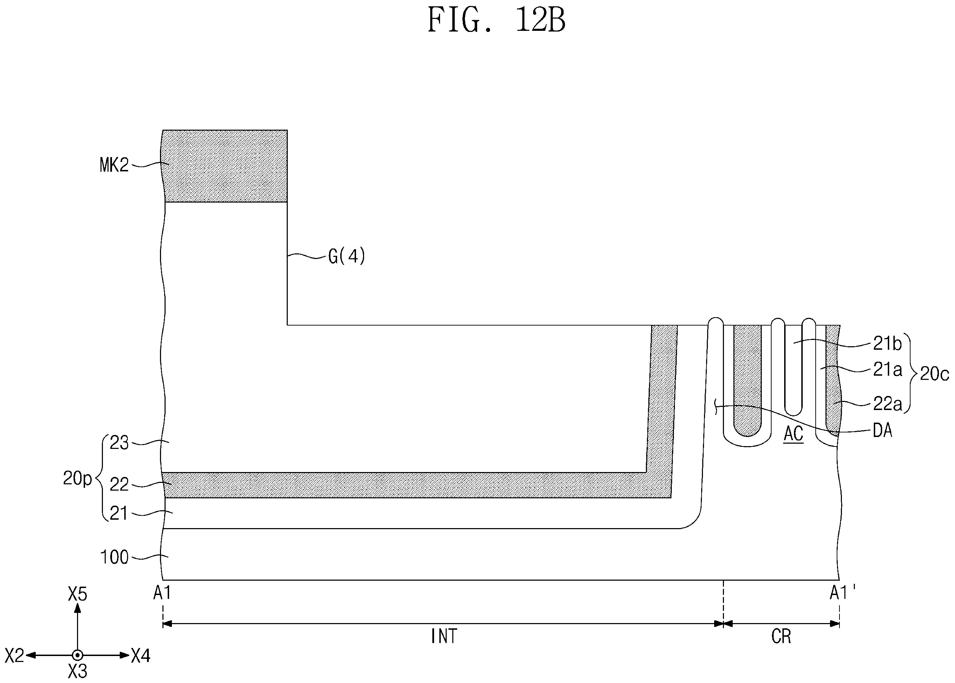

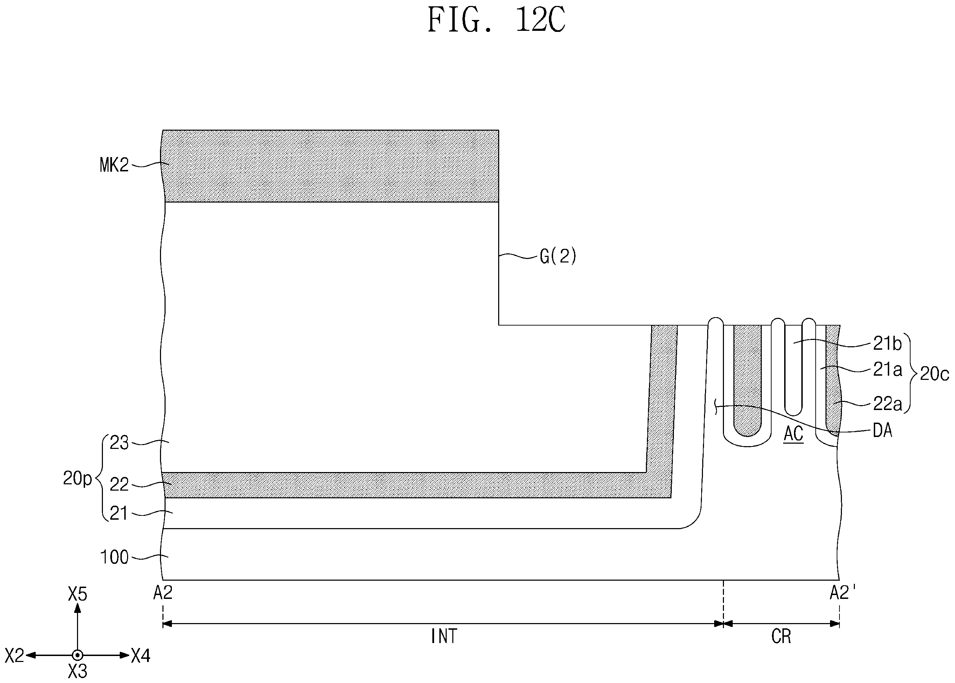

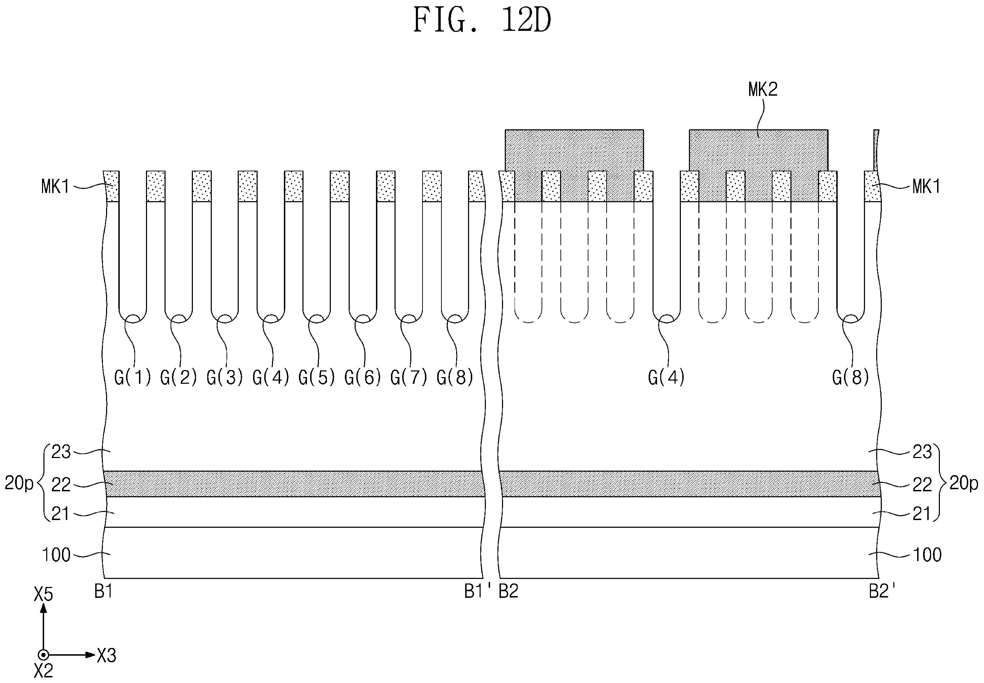

Referring to FIGS. 12A to 12D, grooves G may be formed by etching the substrate 100 and the first and second device isolation portions 20c and 20p using the line mask patterns MK1 and the first cover mask pattern MK2 as an etch mask. The grooves G may include first to eighth grooves G(1) to G(8), which are sequentially placed, and spaced apart from one another, in the third direction X3. Due to the recessed portions MK2_R of the first cover mask pattern MK2, the fourth and eighth grooves G(4) and G(8) may be formed to further extend in the second direction X2, when compared to the first to third grooves G(1) to G(3) and the fifth to seventh grooves G(5) to G(7). For example, the fourth and eighth grooves G(4) and G(8) may extend a longer distance than the first to third grooves G(1) to G(3) and the fifth to seventh grooves G(5) to G(7), due to the fourth and eighth grooves G(4) and G(8) extending into respective recessed portions MK2_R. The grooves G may be formed in the active regions AC and DA. By adjusting the etch selectivity of the substrate 100 and the first and second device isolation portions 20c and 20p in the etching process, the first and second device isolation portions 20c and 20p may be etched at a faster etch rate than the substrate 100. Thus, the substrate 100 may be formed to have an upward protruding shape relative to the first and second device isolation portions 20c and 20p, at the bottom surfaces of the grooves G.

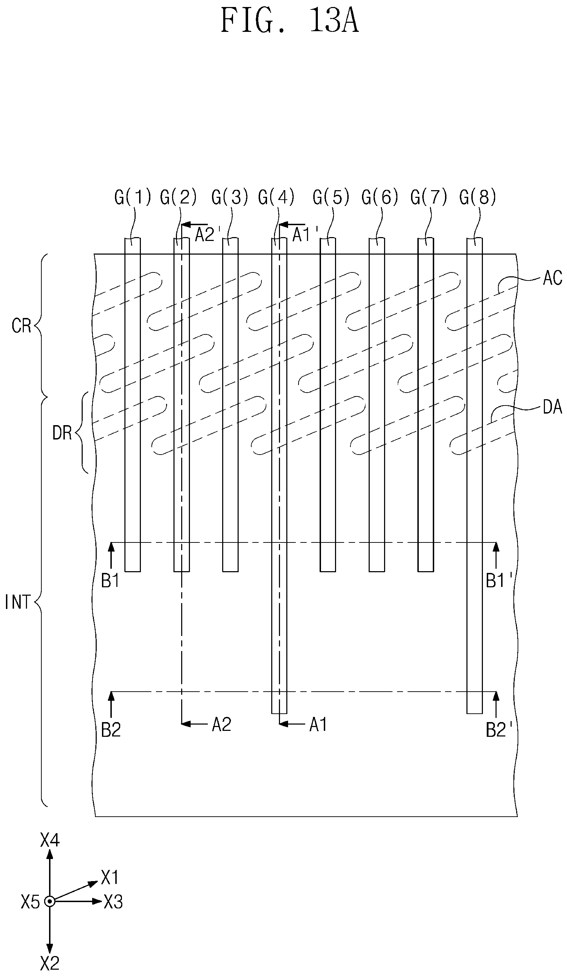

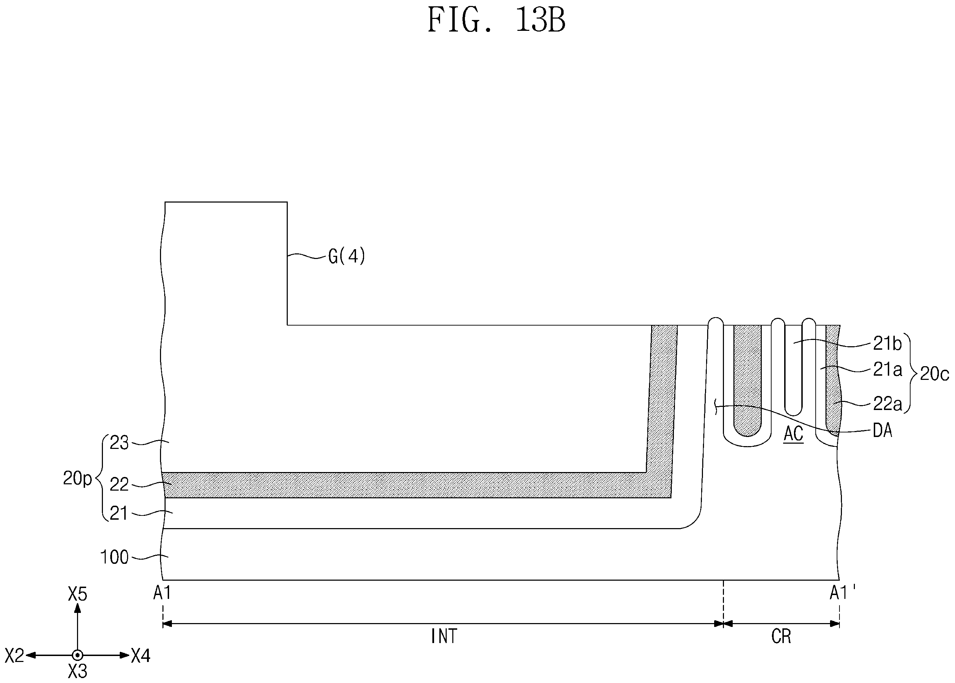

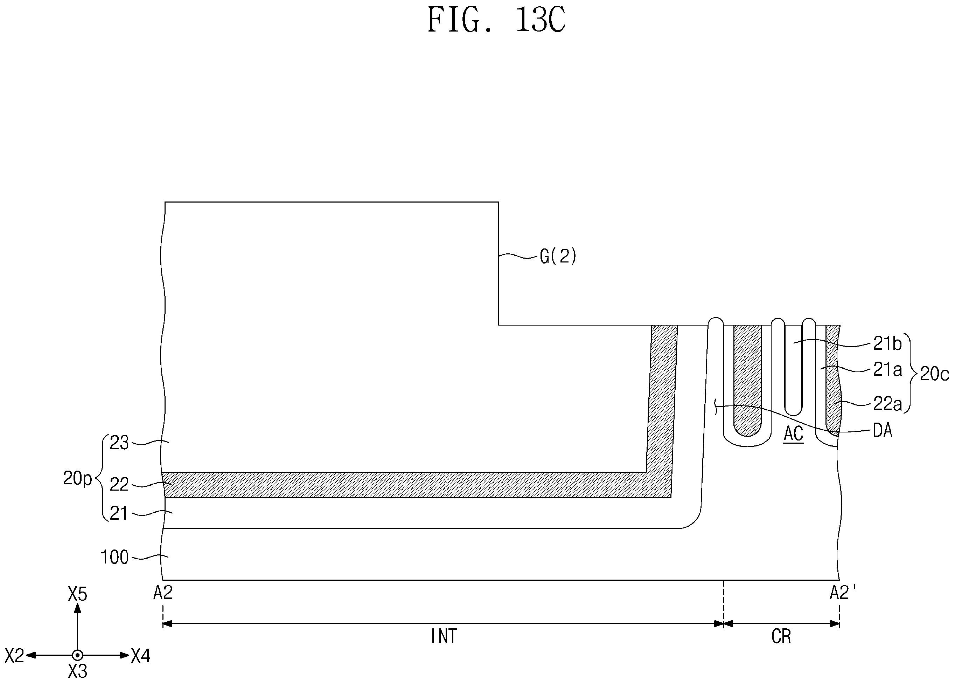

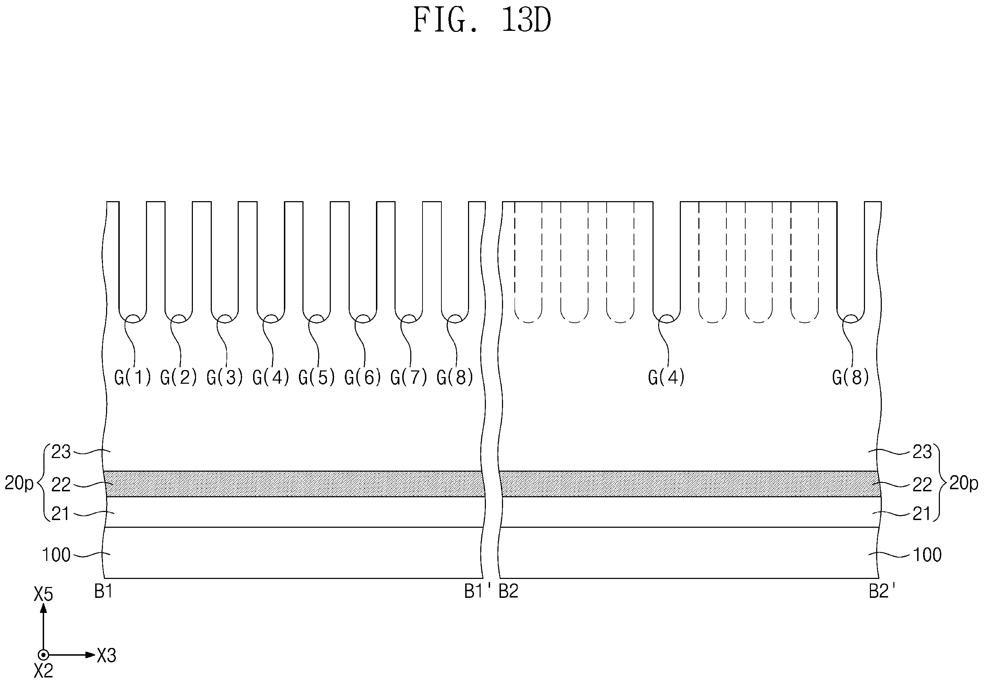

Referring to FIGS. 13A to 13D, the top surfaces of the substrate 100 and the first and second device isolation portions 20c and 20p may be exposed by removing the line mask patterns MK1 and the first cover mask pattern MK2.

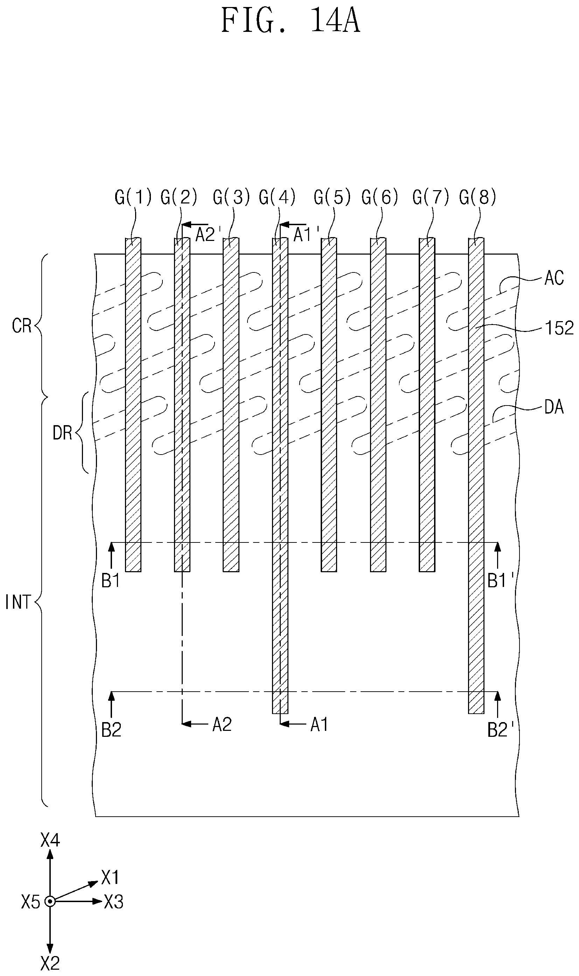

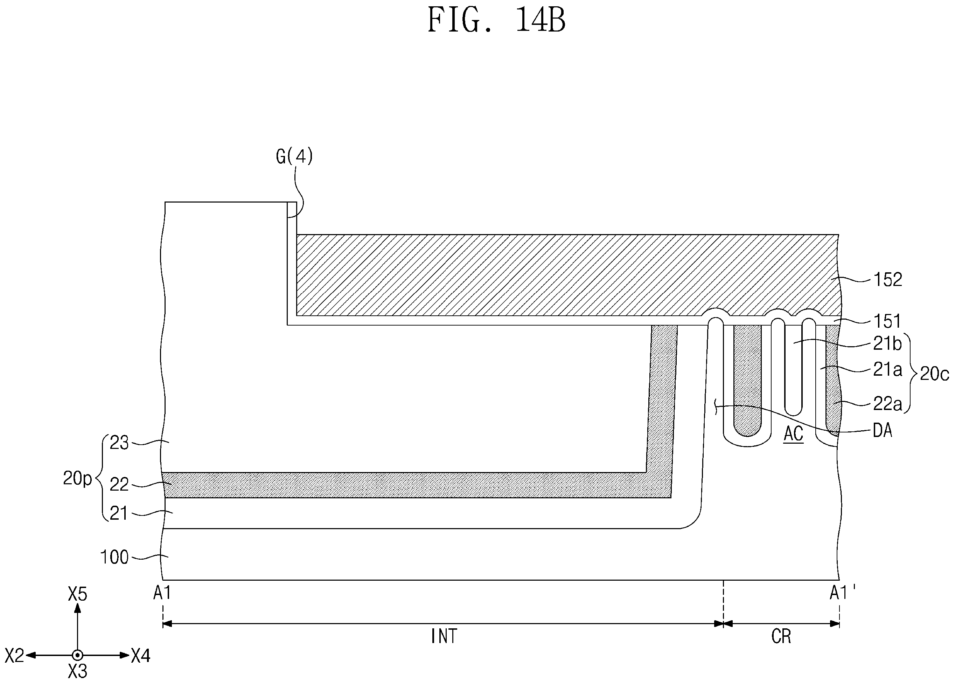

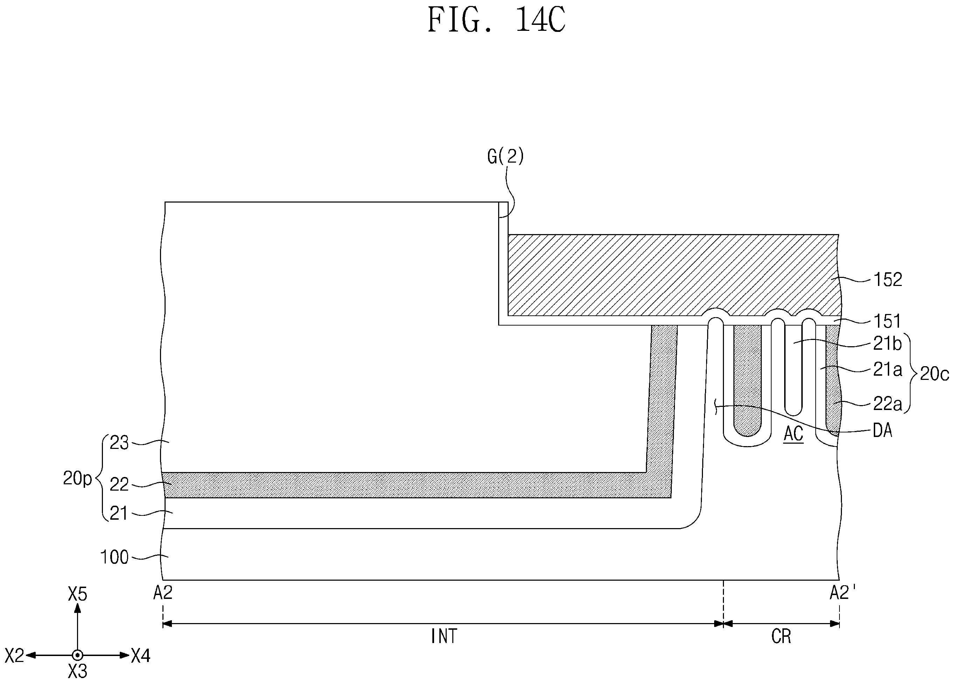

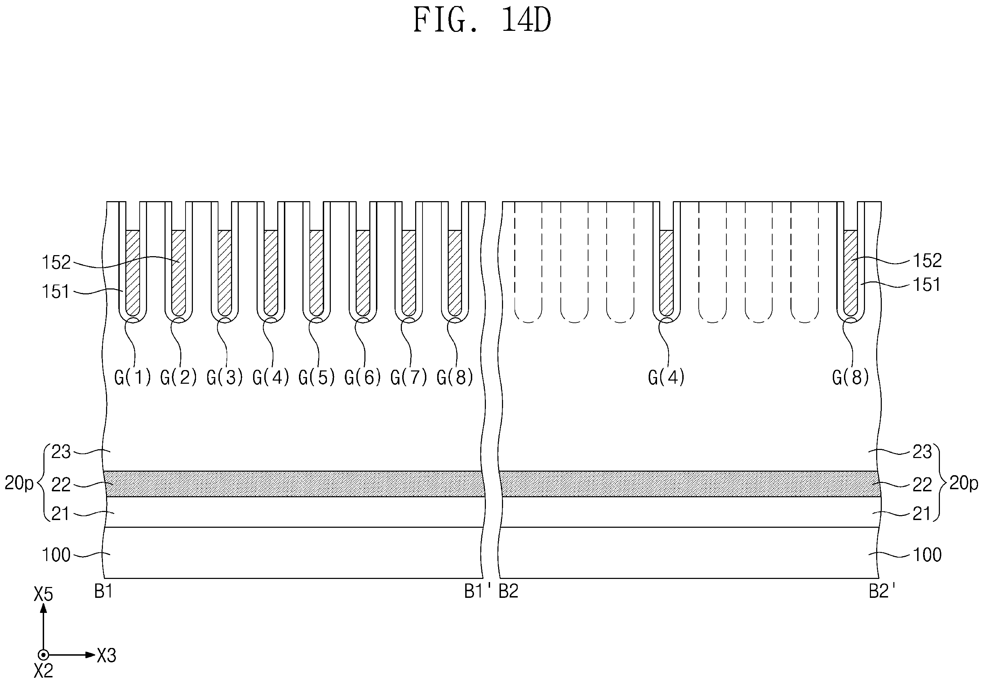

Referring to FIGS. 14A to 14D, a first conductive layer may be formed on the substrate 100 to fill the grooves G, and an etch-back process may be performed on the first conductive layer to form the first conductive patterns 152 in the grooves G. The first conductive layer may be formed of or include at least one of, for example, tungsten and titanium nitride.

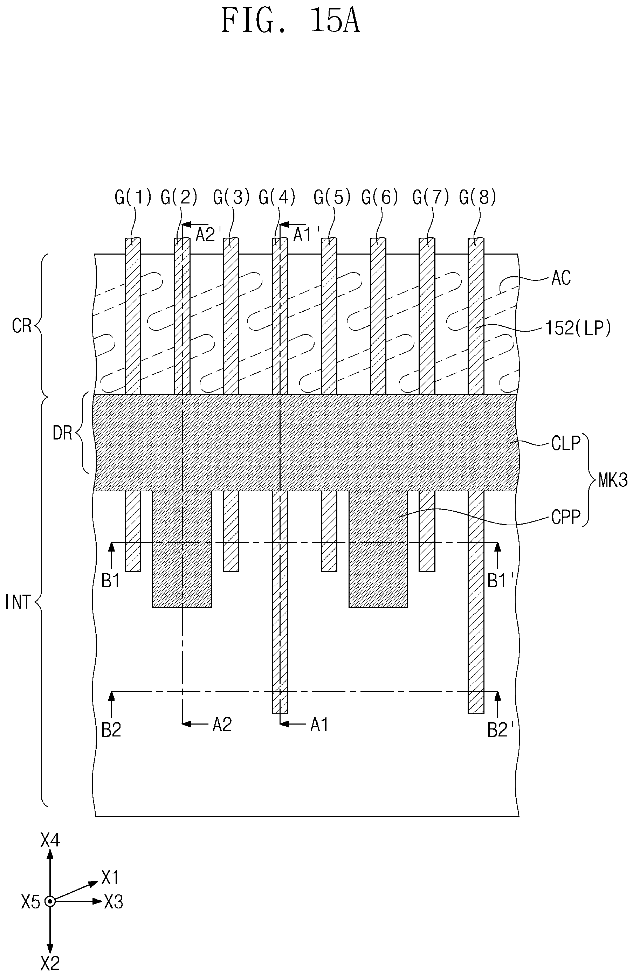

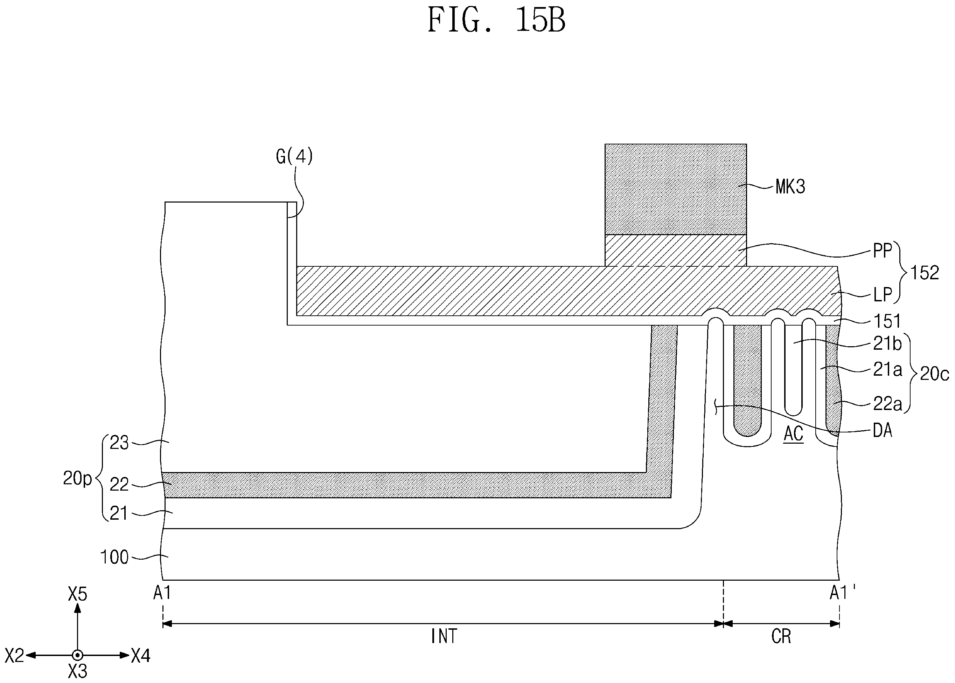

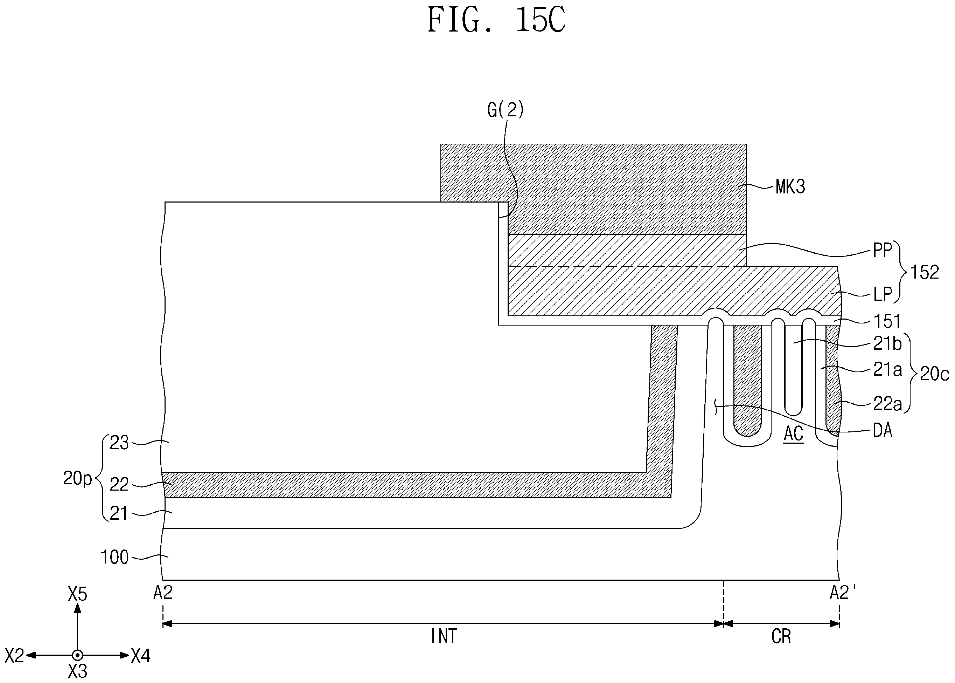

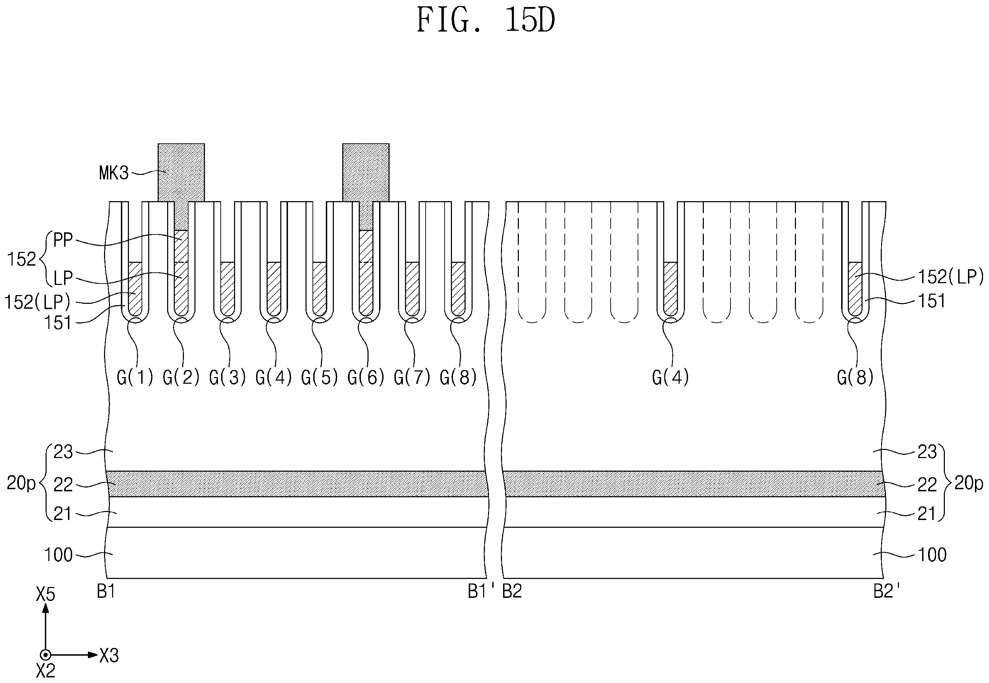

Referring to FIGS. 15A to 15D, a second cover mask pattern MK3 may be formed on the border region INT to cover portions of the first conductive patterns 152. The second cover mask pattern MK3 may include a cover linear portion CLP, which extends in the third direction X3, and cover protruding portions CPP, which extend from the cover linear portion CLP to protrude in the first direction. The cover linear portion CLP may cover a middle or central region of each of the first conductive patterns 152 in the border region INT. In the border region INT, the cover protruding portions CPP may be formed to cover end portions of the second and sixth grooves G(2) and G(6) and to expose end portions of the first, third to fifth, seventh, and eighth grooves G(1), G(3) to G(5), G(7), and G(8). As such, the cover protruding portions CPP may be formed to cover some, but not all, of the end portions of the first conductive patterns 152.

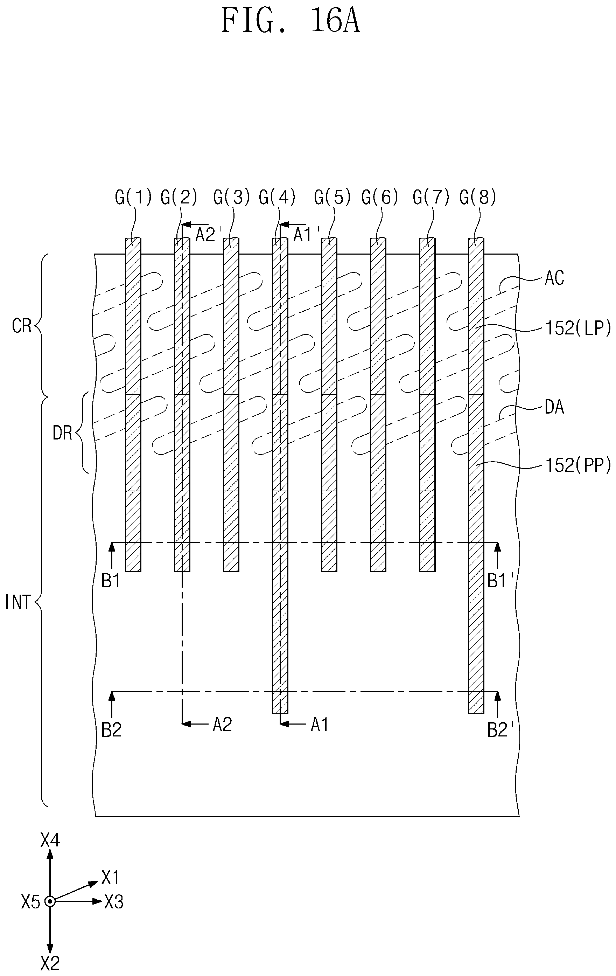

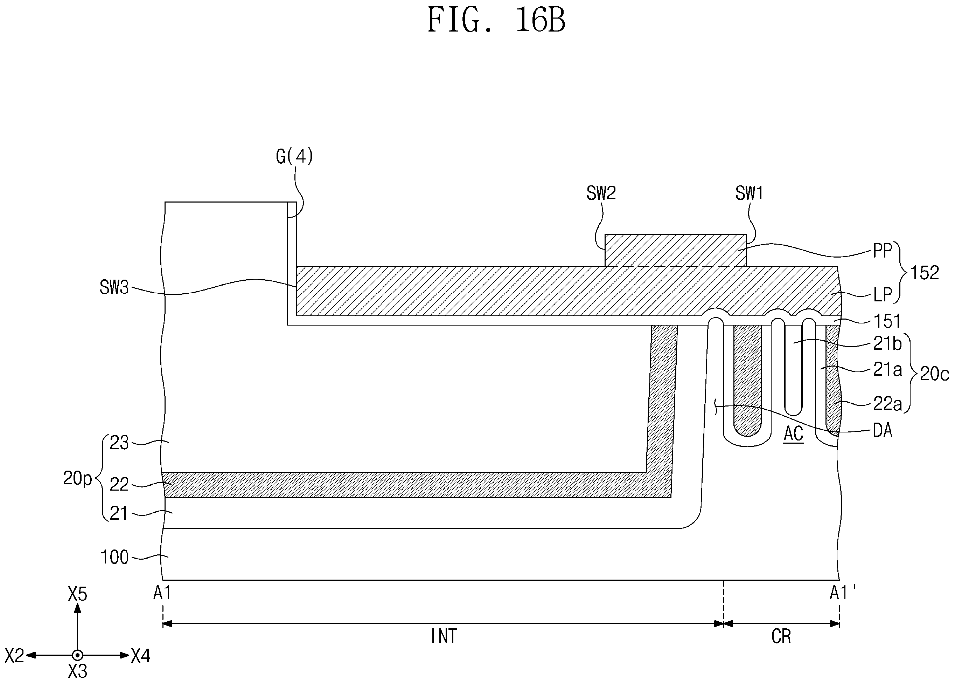

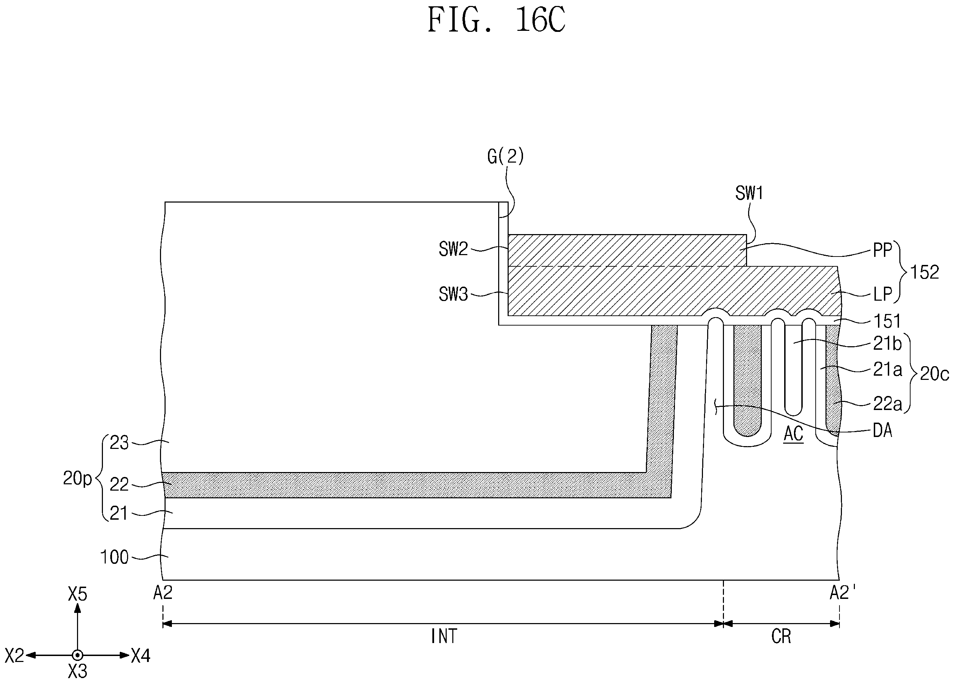

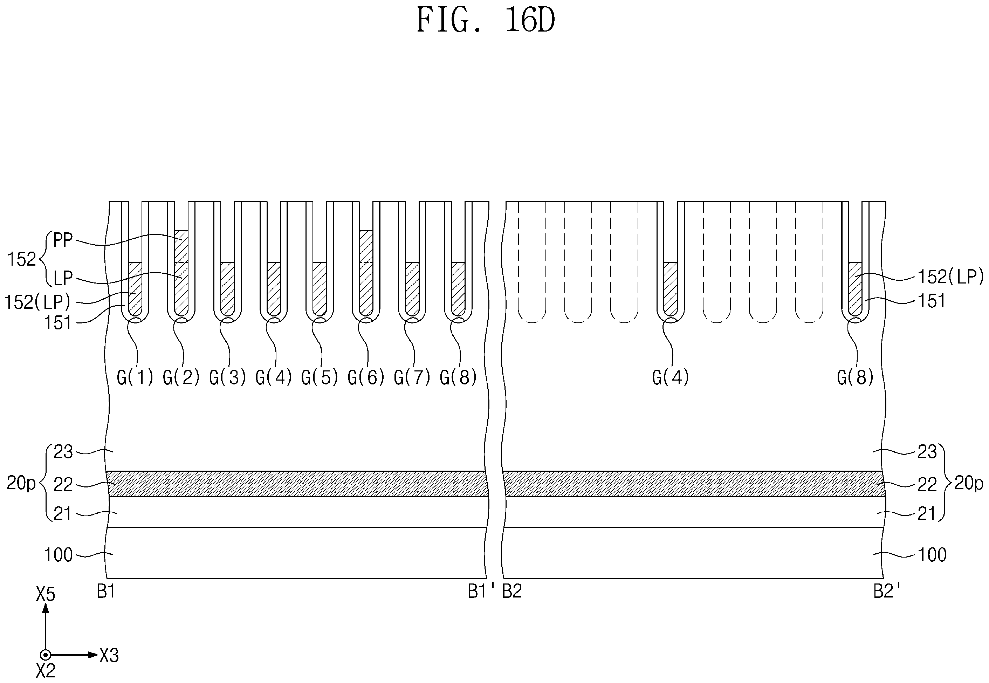

Referring to FIGS. 16A to 16D, the line portions LP and the protruding portions PP may be formed in the first conductive patterns 152 by etching the first conductive pattern 152 using the second cover mask pattern MK3 as an etch mask. The line portions LP and the protruding portions PP may be provided to have the same shape as described above, such that, as a result of the etching, a thickness of the line portions LP may be reduced, while the protruding portions PP may not be etched. The second cover mask pattern MK3 may be removed after etching of the line portions LP.

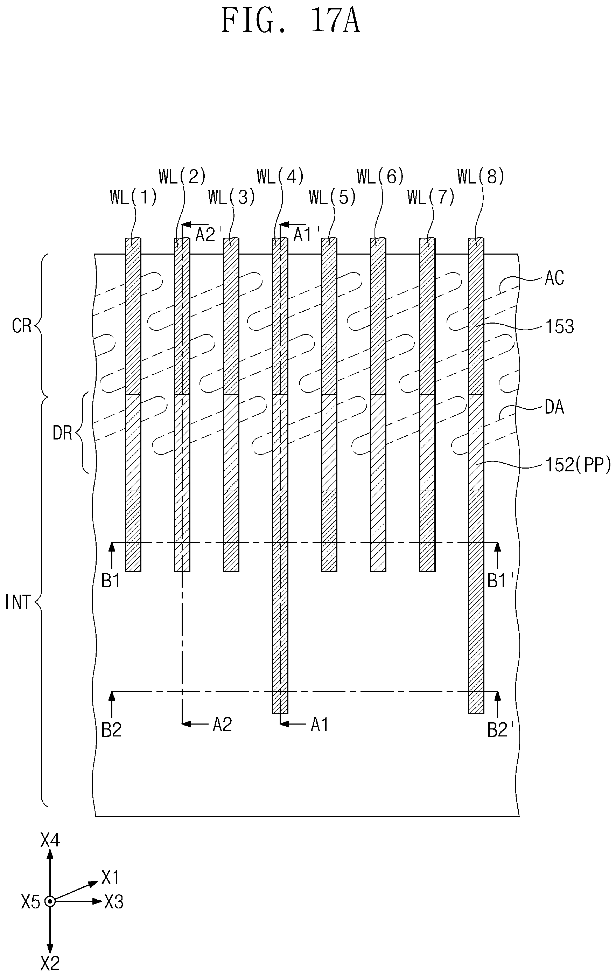

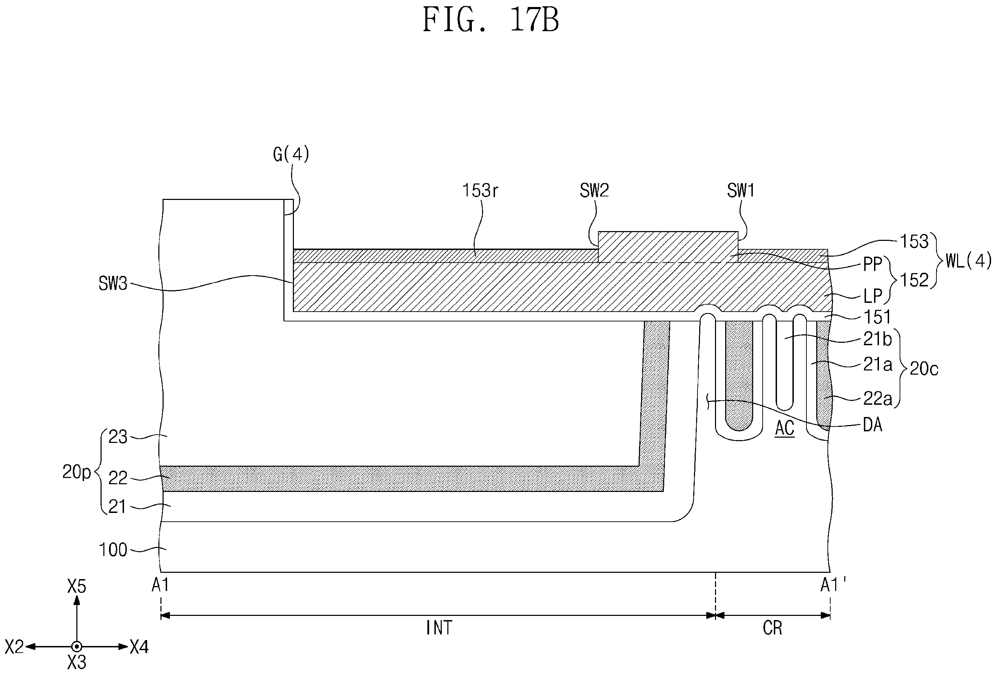

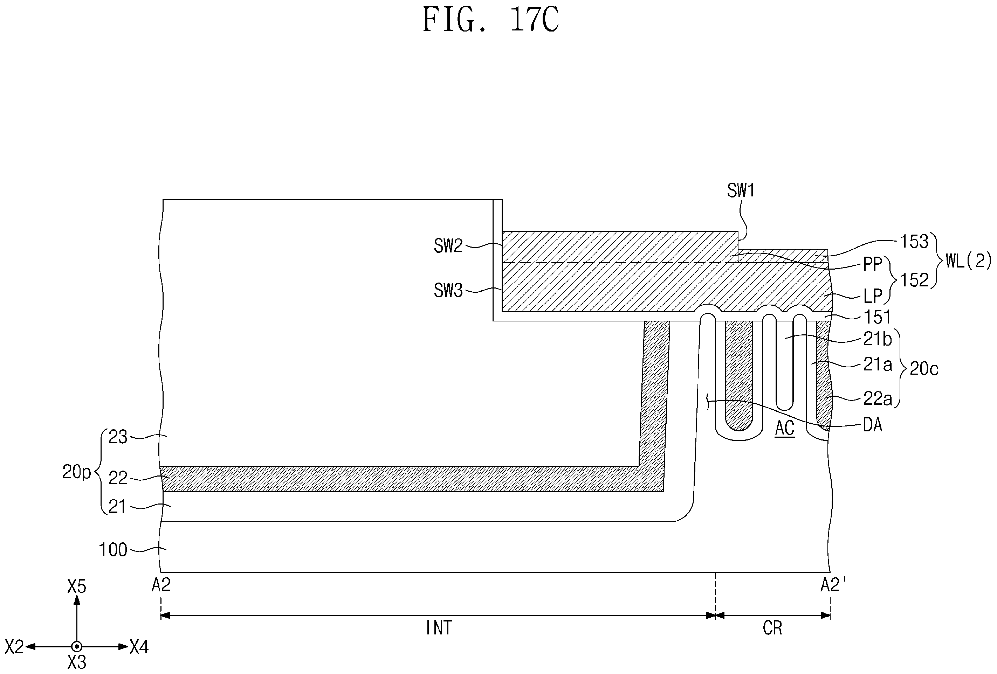

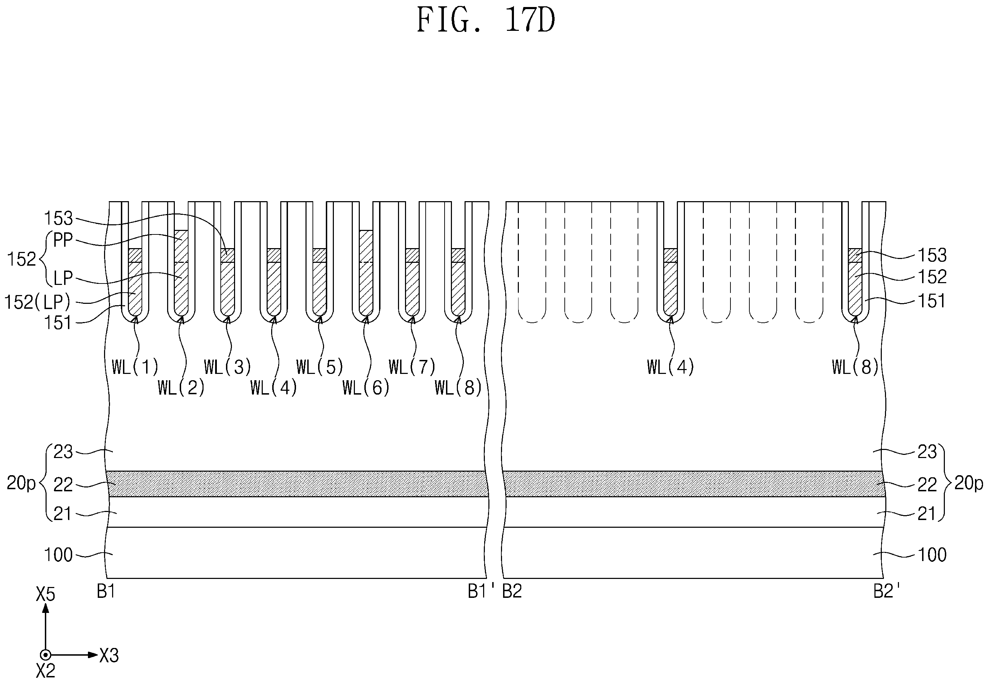

Referring to FIGS. 17A to 17D, a second conductive layer may be stacked on the first conductive pattern 152, and an etch-back process may be performed on the second conductive layer to form the second conductive pattern 153 and the second remaining conductive pattern 153r. The second conductive pattern 153 and the second remaining conductive pattern 153r may expose upper portions of the side surfaces SW1 and SW2 of the protruding portions PP of the first conductive pattern 152.

Referring back to FIGS. 2A to 8C, the first capping patterns 154, the bit lines BL, the interlayer insulating layer 250, and the first and second contact plugs WC1 and WC2 may be formed. As shown in FIGS. 2A, 4A, and 4B, since the distance between the first and second contact plugs WC1 and WC2 is large, it may be possible to increase the process margin in the process of forming the first and second contact plugs WC1 and WC2, thereby reducing the process failure. In particular, since other word lines WL are not disposed near the second contact plugs WC2, the second contact plugs WC2 may be formed to have a larger width than the first contact plugs WC1. The first and second contact plugs WC1 and WC2 may be formed at the same time or through different process steps.

In a semiconductor memory device according to an embodiment, word lines may be formed to have different lengths in a border region, and thus, contact plugs may be formed in a zigzag shape. A distance between the contact plugs may be larger than a distance between the word lines, and in this case, it may be possible to prevent a bridge issue or a short circuit issue. In addition, the contact plugs may be formed to have different depths, and in this case, it may be possible to prevent the bridge issue or the short circuit issue more effectively. Thus, the reliability of the semiconductor memory device may be improved.

In a method of fabricating a semiconductor device, since the distance between the contact plugs is larger than the distance between the word lines, it may be possible to increase a process margin and to reduce a process failure. Accordingly, it may be possible to increase a yield in the fabrication process.

While example embodiments have been particularly shown and described, it will be understood by one of ordinary skill in the art that variations in form and detail may be made therein without departing from the spirit and scope of the attached claims. The embodiments of FIGS. 1 to 8C may be variously combined.

## Claims

1. A semiconductor memory device, comprising:
a substrate including a cell region and a border region; and
first to eighth word lines disposed in the substrate to cross the cell region and extending to the border region in a first direction,
wherein the first to eighth word lines are sequentially disposed in a second direction that is perpendicular to the first direction, and the first to eighth word lines are sequentially disposed in the order of the first word line, followed by the second word line, followed by the third word line, followed by the fourth word line, followed by the fifth word line, followed by the sixth word line, followed by the seventh word line, and followed by the eighth word line, and
on the border region, the fourth and eighth word lines extend in the first direction a greater distance than the first to third word lines and the fifth to seventh word lines, when viewed in a plan view.

2. The semiconductor memory device of claim 1, wherein each of the first to eighth word lines comprises a first conductive pattern,
the first conductive pattern comprises a line portion, which extends through the cell region and into the border region, and a protruding portion, which is provided on the line portion in the border region,
in the first, third to fifth, seventh, and eighth word lines, the protruding portion has a first length in the first direction,
in the second and sixth word lines, the protruding portion has a second length in the first direction, when viewed in a plan view, and
the second length is larger than the first length.

3. The semiconductor memory device of claim 2, wherein, in each of the first to eighth word lines, the protruding portion has a first side surface, which is adjacent to the cell region, and a second side surface, which is opposite to the first side surface,
the first side surfaces of the protruding portions of the first, third to fifth, seventh, and eighth word lines are aligned along the second direction, when viewed in a plan view, and
the second side surfaces of the protruding portions of the second and sixth word lines are not aligned with the second side surfaces of the protruding portions of the first, third to fifth, seventh, and eighth word lines along the second direction, in a plan view.

4. The semiconductor memory device of claim 3, wherein each of the first to eighth word lines further comprises a second conductive pattern, which is positioned on the line portion of the first conductive pattern and is in contact with the first side surface of the protruding portion.

5. The semiconductor memory device of claim 4, wherein each of the first to eighth word lines further comprises a second remaining conductive pattern, which is positioned on the line portion of the first conductive pattern and is in contact with the second side surface of the protruding portion and is spaced apart from the second conductive pattern.

6. The semiconductor memory device of claim 5, wherein the first conductive pattern is formed of a first conductive material, and
the second conductive pattern and the second remaining conductive pattern is formed of a second conductive material different from the first conductive material.

7. The semiconductor memory device of claim 4, wherein a top surface of the protruding portion is at a first level, and
a top surface of the second conductive pattern is at a second level lower than the first level.

8. The semiconductor memory device of claim 1, further comprising:
first contact plugs provided on the border region and in contact with end portions of the second and sixth word lines; and
second contact plugs provided on the border region and in contact with end portions of the fourth and eighth word lines,
wherein the second contact plugs are offset from the first contact plugs relative to the first direction, when viewed in a plan view.

9. The semiconductor memory device of claim 8, wherein a first distance between the first contact plugs and the cell region is smaller than a second distance between the second contact plugs and the cell region.

10. The semiconductor memory device of claim 8, wherein bottom surfaces of the first contact plugs are at a first level, and
bottom surfaces of the second contact plugs are at a second level that is lower than the first level.

11. The semiconductor memory device of claim 8, wherein the first contact plugs have a first width in the second direction, and
the second contact plugs have a second width, which is larger than the first width, in the second direction.

12. The semiconductor memory device of claim 8, wherein the second contact plugs are in contact with top and side surfaces of the end portions of the fourth and eighth word lines.

13. The semiconductor memory device of claim 1, wherein each of the first to eighth word lines comprises a first conductive pattern and a second conductive pattern, which are sequentially stacked, and
the second contact plugs extend through the second conductive patterns of the fourth and eighth word lines and contact top surfaces of the first conductive patterns.

## Amended claims

### Amended claims in accordance with Rule 137(2) EPC.

1. A semiconductor memory device, comprising:
a substrate (100) including a cell region (CR) and a border region (INT); and
first to eighth word lines (WL(1),..., WL(8)) disposed in the substrate (100) to cross the cell region (CR) and extending to the border region (INT) in a first direction (X2),
wherein the first to eighth word lines (WL(1),..., WL(8)) are sequentially disposed in a second direction (X3) that is perpendicular to the first direction (X2), and the first to eighth word lines (WL(1),..., WL(8)) are sequentially disposed in the order of the first word line (WL(1)), followed by the second word line (WL(2)), followed by the third word line (WL(3)), followed by the fourth word line (WL(4)), followed by the fifth word line (WL(5)), followed by the sixth word line (WL(6)), followed by the seventh word line (WL(7)), and followed by the eighth word line (WL(8)), and
on the border region (INT), the fourth and eighth word lines (WL(4), WL(8)) extend in the first direction (X2) a greater distance (LT3) than the first to third word lines (WL(1), WL(2), WL(3)) and the fifth to seventh word lines (WL(5), WL(6), WL(7)), when viewed in a plan view,
wherein each of the first to eighth word lines (WL(1),..., WL(8)) comprises a first conductive pattern (152), the first conductive pattern (152) comprising a line portion (LP), which extends through the cell region (CR) and into the border region (INT), and
**characterized in that**
the first conductive pattern (152) further comprises a protruding portion (PP), which is provided on the line portion (LP) in the border region (INT), and
the protruding portion (PP) of one or more of the first to eighth word lines (WL(1),..., WL(8)) has a different length in the first direction (X2) than the protruding portion (PP) of the others of the first to eighth word lines (WL(1),..., WL(8)).

2. The semiconductor memory device of claim 1, wherein:
in the first, third to fifth, seventh, and eighth word lines (WL(1), WL(3), WL(4), WL(5), WL(7), WL(8)), the protruding portion (PP) has a first length (LT1) in the first direction (X2),
in the second and sixth word lines (WL(2), WL(6)), the protruding portion (PP) has a second length (LT2) in the first direction (X2), when viewed in a plan view, and
the second length (LT2) is larger than the first length (LT1).

3. The semiconductor memory device of claim 2, wherein, in each of the first to eighth word lines (WL(1),..., WL(8)), the protruding portion (PP) has a first side surface (SW1), which is adjacent to the cell region (CR), and a second side surface (SW2), which is opposite to the first side surface (SW1),
the first side surfaces (SW1) of the protruding portions (PP) of the first, third to fifth, seventh, and eighth word lines (WL(1), WL(3), WL(4), WL(5), WL(7), WL(8)) are aligned along the second direction (X3), when viewed in a plan view, and
the second side surfaces (SW2) of the protruding portions (PP) of the second and sixth word lines (WL(2), WL(6)) are not aligned with the second side surfaces (SW2) of the protruding portions (PP) of the first, third to fifth, seventh, and eighth word lines (WL(1), WL(3), WL(4), WL(5), WL(7), WL(8)) along the second direction (X3), in a plan view.

4. The semiconductor memory device of claim 3, wherein each of the first to eighth word lines (WL(1),..., WL(8)) further comprises a second conductive pattern (153), which is positioned on the line portion (LP) of the first conductive pattern (152) and is in contact with the first side surface (SW1) of the protruding portion (PP).

5. The semiconductor memory device of claim 4, wherein each of the first to eighth word lines (WL(1),..., WL(8)) further comprises a second remaining conductive pattern (153r), which is positioned on the line portion (LP) of the first conductive pattern (152) and is in contact with the second side surface (SW2) of the protruding portion (PP) and is spaced apart from the second conductive pattern (153).

6. The semiconductor memory device of claim 5, wherein the first conductive pattern (152) is formed of a first conductive material, and
the second conductive pattern (153) and the second remaining conductive pattern (153r) is formed of a second conductive material different from the first conductive material.

7. The semiconductor memory device of claim 4, wherein a top surface of the protruding portion (PP) is at a first level (LV1), and
a top surface of the second conductive pattern (153) is at a second level (LV2) lower than the first level (LV1).

8. The semiconductor memory device of claim 1, further comprising:
first contact plugs (WC1) provided on the border region (INT) and in contact with end portions of the second and sixth word lines (WL(2), WL(6)); and
second contact plugs (WC2) provided on the border region (INT) and in contact with end portions of the fourth and eighth word lines (WL(4), WL(8)),
wherein the second contact plugs (WC2) are offset from the first contact plugs (WC1) relative to the first direction (X2), when viewed in a plan view.

9. The semiconductor memory device of claim 8, wherein a first distance between the first contact plugs (WC1) and the cell region (CR) is smaller than a second distance between the second contact plugs (WC2) and the cell region (CR).

10. The semiconductor memory device of claim 8, wherein bottom surfaces of the first contact plugs (WC1) are at a first level (LV1), and
bottom surfaces of the second contact plugs (WC2) are at a second level (LV3) that is lower than the first level (LV1).

11. The semiconductor memory device of claim 8, wherein the first contact plugs (WC1) have a first width (WT1) in the second direction (X3), and
the second contact plugs (WC2) have a second width (WT2), which is larger than the first width (WT1), in the second direction (X3).

12. The semiconductor memory device of claim 8, wherein the second contact plugs (WC2) are in contact with top and side surfaces of the end portions of the fourth and eighth word lines (WL(4), WL(8)).

13. The semiconductor memory device of claim 1, wherein each of the first to eighth word lines (WL(1),..., WL(8)) comprises a first conductive pattern (152) and a second conductive pattern (153), which are sequentially stacked, and
the second contact plugs (WC2) extend through the second conductive patterns (153) of the fourth and eighth word lines (WL(4), WL(8)) and contact top surfaces of the first conductive patterns (152).
